# EUROPEAN PATENT APPLICATION

(11) **EP 4 842 163 A2**
(43) Date of publication of application: **18.11.2026**
(21) Application number: 26163257.4
(22) Date of filing: 09.03.2026
(51) Int. Cl.: H10D 88/00, H10D 30/00, H10D 30/01, H10D 30/43, H10D 62/10, H10D 64/01, H10D 84/01, H10D 84/83, H10D 84/85

(54) **THREE-DIMENSIONAL SEMICONDUCTOR DEVICE WITH LOWER GATE CONTACT AND METHOD FOR MANUFACTURING THE SAME**

(30) Priority: 15.05.2025 KR 20250063483
(71) Applicant: Samsung Electronics Co., Ltd., Suwon-si, Gyeonggi-do 16677 (KR)
(72) Inventor: HWANG, Donghoon, 16677 Suwon-si (KR); KIM, Jina, 16677 Suwon-si (KR); JEON, Jaeho, 16677 Suwon-si (KR)
(74) Representative: Marks & Clerk LLP

(57) **Abstract**

A three-dimensional semiconductor device includes a gate electrode including a lower gate electrode and an upper gate electrode, a lower active region including a lower channel pattern, a lower source/drain pattern connected to the lower channel pattern, and the lower gate electrode, an upper active region on the lower active region and including an upper channel pattern, an upper source/drain pattern connected to the upper channel pattern, and the upper gate electrode, and a lower gate contact connected to the lower gate electrode. The lower gate contact includes a first part and also a second part extending from the first part and in contact with the lower gate electrode.

## Description

### BACKGROUND

Semiconductor devices may include integrated circuits including a metal oxide semiconductor field effect transistor (MOSFET). To meet an increasing demand for semiconductor devices with a small pattern size and a reduced design rule, a size of MOSFET has also been scaled down. The scale-down of the MOSFETs may lead to deterioration in operational properties of the semiconductor devices. A variety of studies are being conducted to overcome technical limitations associated with the scale-down of the semiconductor devices and to realize high performance semiconductor devices.

### SUMMARY

Some implementations of this disclosure provide a three-dimensional semiconductor device with improved integration and electrical characteristics.

Some implementations of this disclosure provide a method for manufacturing a three-dimensional semiconductor device with improved integration and electrical characteristics.

Some implementations of this disclosure provide a three-dimensional semiconductor device including a gate electrode including a lower gate electrode and an upper gate electrode, a lower active region including a lower channel pattern, a lower source/drain pattern connected to the lower channel pattern, and the lower gate electrode, an upper active region stacked on the lower active region, and including an upper channel pattern, an upper source/drain pattern connected to the upper channel pattern, and the upper gate electrode, and a lower gate contact connected to the lower gate electrode, wherein the lower gate contact includes a first part, and a second part extending from the first part and in contact with the lower gate electrode, the first part has a greater width than the second part, and a sidewall of the second part has a concave profile.

According to some implementations of this disclosure, a three-dimensional semiconductor device includes a gate electrode including a lower gate electrode and an upper gate electrode, a lower channel pattern, and a lower active region including the lower gate electrode, an upper active region on the lower active region, and including an upper channel pattern, and the upper gate electrode, and a lower gate contact connected to the lower gate electrode, wherein the lower gate electrode includes a first inner electrode under the lower channel pattern, and an edge electrode extending down along a sidewall of the lower channel pattern, a bottom surface of the edge electrode is lower than a bottom surface of the first inner electrode, the lower gate contact includes a first part, and a second part on the first part, the second part protrudes from the first part and is in contact with the lower gate electrode, and the first part includes an upper surface facing the lower gate electrode.

According to some implementations of this disclosure, a three-dimensional semiconductor device includes a gate electrode vertically extending, and including a lower gate electrode and an upper gate electrode which extend in a first direction, a lower channel pattern including a plurality of stacked lower semiconductor patterns, and a lower active region including the lower gate electrode, an upper active region stacked on the lower active region, and including the upper gate electrode and an upper channel pattern which includes a plurality of stacked upper semiconductor patterns, a lower source/drain pattern connected to the lower channel pattern, and an upper source/drain pattern connected to the upper channel pattern, a lower active contact connected to the lower source/drain pattern, and an upper active contact connected to the upper source/drain pattern, a lower gate contact electrically connected to the lower gate electrode, and an upper gate contact electrically connected to the upper gate electrode, a contact spacer on a sidewall of the lower gate contact, a cutting pattern vertically penetrating the lower active region and the upper active region, and a first metal layer on the upper gate electrode, and a backside metal layer under the lower gate electrode, wherein the lower gate contact includes a first part, and a second part vertically extending from the first part to be in contact with the lower gate electrode, the contact spacer includes a first contact spacer on a sidewall of the first part, and a second contact spacer interposed between a sidewall of the second part and the lower gate electrode, and an upper surface of the second contact spacer has a higher level than a bottom surface of the lower gate electrode, and has a lower level than an upper surface of the second part.

According to some implementations of this disclosure, a method for manufacturing a three-dimensional semiconductor device includes forming sacrificial contact patterns in a substrate, forming a buffer layer on the sacrificial contact patterns, forming, on the buffer layer, a stack pattern in which sacrificial layers and active layers are alternately stacked, forming a lower gate electrode by selectively etching the sacrificial layers, and forming a lower gate contact connected to the lower gate electrode, wherein the lower gate contact includes a first part, and a second part vertically extending from the first part to be in contact with the lower gate electrode, the first part has a greater width than the second part, and the buffer layer includes a material having etching selectivity with respect to the sacrificial layers and the sacrificial contact patterns.

In the method for manufacturing a semiconductor device according to this disclosure, the buffer layer may be formed so as to completely cover upper surfaces of the sacrificial contact patterns.

In the method for manufacturing a semiconductor device according to this disclosure, the forming of the lower gate contact may include removing the substrate and the buffer layer.

In the method for manufacturing a semiconductor device according to this disclosure, the method for manufacturing a three-dimensional semiconductor device may further include forming a contact spacer on a sidewall of the lower gate contact, wherein the contact spacer may include a first contact spacer on a sidewall of the first part, and a second contact spacer interposed between a sidewall of the second part and the lower gate electrode.

In the method for manufacturing a semiconductor device according to this disclosure, the second part may include a sidewall having a concave profile.

At least some of the above and other features of the invention are set out in the claims.

### BRIEF DESCRIPTION OF THE DRAWINGS

The accompanying drawings are included to provide a further understanding of this disclosure. The drawings illustrate implementations of this disclosure and, together with the description, serve to explain principles of this disclosure. In the drawings:
FIG. 1 is a conceptual view for describing a logic cell of a semiconductor device according to a comparative example of this disclosure;
FIG. 2 is a conceptual view for describing a logic cell of a semiconductor device according to implementations of this disclosure;
FIG. 3 is a plan view for describing a three-dimensional semiconductor device according to implementations of this disclosure;
FIG. 4A is a cross-sectional view taken along line A-A' of FIG. 3;
FIG. 4B is a cross-sectional view taken along line B-B' of FIG. 3;
FIG. 4C is a cross-sectional view taken along line C-C' of FIG. 3;
FIG. 5A is an enlarged view taken along region M of FIG. 4C according to some implementations of this disclosure;
FIG. 5B is an enlarged view taken along region M of FIG. 4C according to some other implementations of this disclosure; and
FIGS. 6, 7A, 7B, 8A, 8B, 9, 10A, 10B, 11, 12A, 12B, 13A, 13B, 14, 15A, 15B, 16A, 16B, and 17 are cross-sectional views for describing a method for manufacturing a semiconductor device according to implementations of this disclosure.

### DETAILED DESCRIPTION

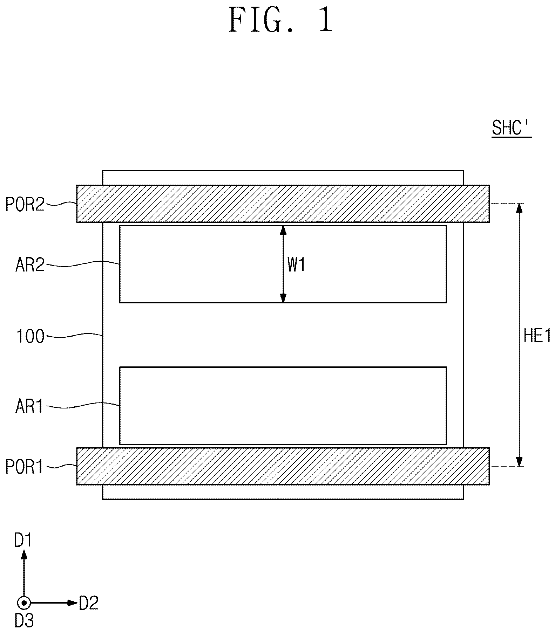

FIG. 1 is a conceptual view for describing a logic cell of a semiconductor device according to a comparative example of this disclosure. FIG. 1 illustrates the logic cell of a two-dimensional device according to a comparative example of this disclosure.

Referring to FIG. 1, a single height cell SHC' may be provided. Specifically, a first power line POR1 and a second power line POR2 may be provided on a substrate 100. A drain voltage VDD, that is, a power voltage may be applied to any one of the first power line POR1 and the second power line POR2. A source voltage VSS, that is, a ground voltage may be applied to the other one of the first power line POR1 and the second power line POR2. For example, the source voltage VSS may be applied to the first power line POR1, and the drain voltage VDD may be applied to the second power line POR2.

The single height cell SHC' may be defined between the first power line POR1 and the second power line POR2. The single height cell SHC' may include a first active region AR1 and a second active region AR2. Any one of the first and second active regions AR1 and AR2 may be a PMOSFET region and the other one of the first and second active regions AR1 and AR2 may be an NMOSFET region. For example, the first active region AR1 may be an NMOSFET region, and the second active region AR2 may be a PMOSFET region. In other words, the single height cell SHC' may have a structure of a CMOS provided between the first power line POR1 and the second power line POR2.

The semiconductor device according to a comparative example is a two-dimensional device, and transistors of a front end of line (FEOL) layer may be two-dimensionally arranged therein. For example, NMOSFETs of the first active region AR1 and PMOSFETs of the second active region AR2 may be formed spaced apart from each other in a first direction D1.

The first and second active regions AR1 and AR2 may each have a first length W1 in the first direction D1. A length of the single height cell SHC' in the first direction D1 according to a comparative example may be defined as a first height HE1. The first height HE1 may be substantially the same as a distance (for example, a pitch) between the first power line POR1 and the second power line POR2.

The single height cell SHC' may constitute one logic cell. In the present specification, the logic cell may mean a logic element (for example, AND, OR, XOR, XNOR, an inverter, or the like) that performs a specific function. That is, the logic cell may include transistors for constituting the logic element and lines connecting the transistors to each other.

Since the single height cell SHC' according to a comparative example includes a two-dimensional device, the first active region AR1 and the second active region AR2 are disposed not overlapping each other but spaced apart from each other in the first direction D1. Accordingly, the first height HE1 of the single height cell SHC' is required to be defined so as to include all of the first and second active regions AR1 and AR2 spaced apart from each other in the first direction D1. As a result, the first height HE1 of the single height cell SHC' according to a comparative example inevitably becomes relatively large. In other words, the single height cell SHC' according to a comparative example may have a relatively large area.

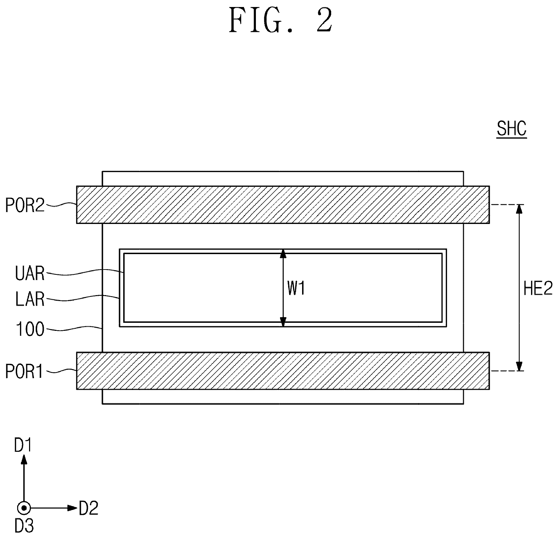

FIG. 2 is a conceptual view for describing a logic cell of a semiconductor device according to implementations of this disclosure. FIG. 2 illustrates the logic cell of a three-dimensional device according to some implementations of this disclosure.

Referring to FIG. 2, a single height cell SHC including the three-dimensional device (for example, a stack transistor) may be provided. Specifically, a first power line POR1 and a second power line POR2 may be provided on a substrate 100. The single height cell SHC may be defined between the first power line POR1 and the second power line POR2.

The single height cell SHC may include a lower active region LAR and an upper active region UAR. Any one of the lower active region LAR and the upper active region UAR may be a PMOSFET region and the other one of the lower active region LAR and the upper active region UAR may be an NMOSFET region.

The semiconductor device according to some implementations is a three-dimensional device, and transistors of the front end of line (FEOL) layer may be vertically stacked. The lower active region LAR may be provided on the substrate 100 as a bottom tier, and the upper active region UAR may be stacked on the lower active region LAR as a top tier. For example, an NMOSFET of the lower active region LAR may be provided on the substrate 100, and a PMOSFET of the upper active region UAR may be stacked on the NMOSFET. The lower active region LAR and the upper active region UAR may be spaced apart from each other in a third direction D3, which is a vertical direction.

Each of the lower active region LAR and the upper active region UAR may have the first length W1 in the first direction D1. A length of the single height cell SHC in the first direction D1 according to some implementations may be defined as a second height HE2.

Since the single height cell SHC according to some implementations includes a three-dimensional device, that is, a stacked transistor, the lower active region LAR and the upper active region UAR may overlap each other. Accordingly, the second height HE2 of the single height cell SHC may have a size capable of including the first length W1 described above. As a result, the second height HE2 of the single height cell SHC according to some implementations may be smaller than the first height HE1 of the single height cell SHC' of FIG. 1 described above. In other words, the single height cell SHC according to some implementations may have a relatively small area. In the three-dimensional semiconductor device according to some implementations, integration may be improved by reducing an area of the logic cell.

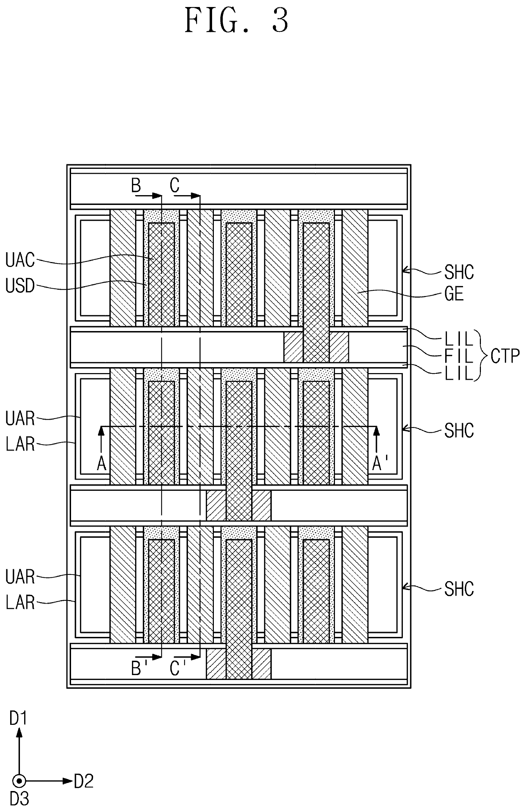

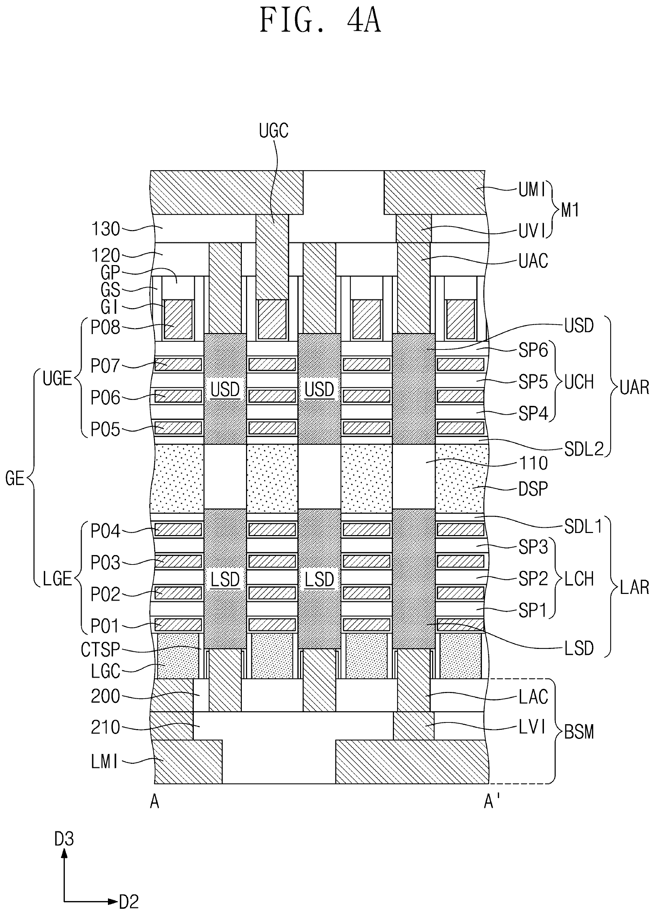

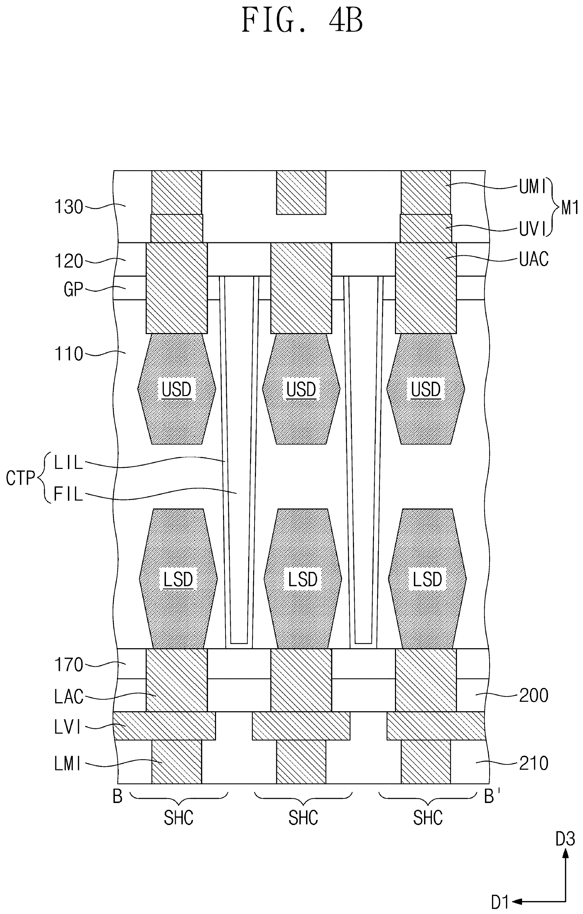

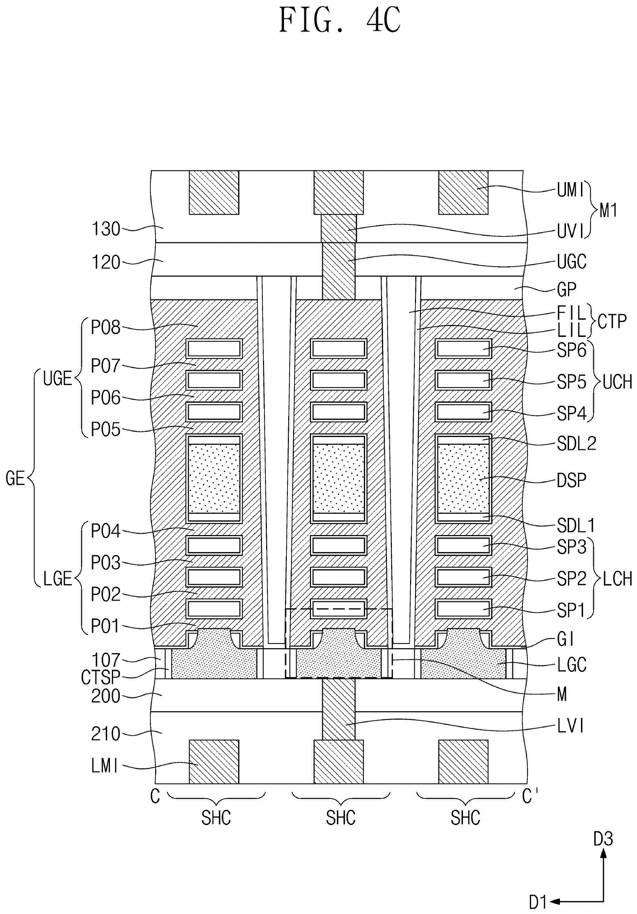

FIG. 3 is a plan view for describing a three-dimensional semiconductor device according to implementations of this disclosure. FIGS. 4A, 4B, and 4C are cross-sectional views respectively taken along line A-A', line B-B', and line C-C' of FIG. 3. The three-dimensional semiconductor devices illustrated in FIGS. 3, and 4A, 4B, and 4C are examples more specifically illustrating the single height cell of FIG. 2.

Referring to FIGS. 3, 4A, 4B, and 4C, the single height cells SHC may be provided. Each of the single height cells SHC may be a logic cell that constitutes a logic circuit. Each of the single height cells SHC may be the logic cell including the three-dimensional device described with reference to FIG. 2 above. The single height cells SHC may be arranged along the first direction D1.

The single height cell SHC according to this disclosure may be provided without the substrate 100. This implementation is possible because a backside metal layer BSM is formed by completely removing the semiconductor substrate 105 in a manufacturing method to be described later.

Each of the single height cells SHC may include the lower active region LAR and the upper active region UAR sequentially stacked on an element isolation layer 107. The element isolation layer 107 may include an insulating material, and may include, for example, silicon oxide. Any one of the lower and upper active regions LAR and UAR may be a PMOSFET region, and the other one of the lower and upper active regions LAR and UAR may be an NMOSFET region. The lower active region LAR may be provided to the bottom tier of the front end of line (FEOL) layer, and the upper active region UAR may be provided to the top tier of the front end of line (FEOL) layer. The NMOSFET and the PMOSFET of the lower and upper active regions LAR and UAR may be vertically stacked to constitute a three-dimensional stack transistor. In some implementations, the lower active region LAR may be an NMOSFET region, and the upper active region UAR may be a PMOSFET region.

Each of the lower and upper active regions LAR and UAR may have a form of a bar or a line extending in a second direction D2. A cutting pattern CTP may be provided between the single height cells SHC adjacent to each other. The cutting pattern CTP may separate the single height cells SHC adjacent to each other. The single height cells SHC adjacent to each other may be spaced apart from each other in the first direction D1 by the cutting pattern CTP. The cutting pattern CTP may have a form of a bar or a line extending in the second direction D2.

The lower active region LAR including lower channel patterns LCH, lower source/drain patterns LSD and a first seed layer SDL1 may be provided on the single height cell SHC. The lower channel pattern LCH may be interposed between a pair of lower source/drain patterns LSD. The lower channel pattern LCH may connect the pair of lower source/drain patterns LSD to each other.

The lower channel pattern LCH may include a first semiconductor pattern SP1, a second semiconductor pattern SP2, and a third semiconductor pattern SP3 stacked spaced apart from each other. Each of the first to third semiconductor patterns SP1, SP2, and SP3 may include silicon (Si), germanium (Ge), or silicon-germanium (SiGe). Preferably, each of the first to third semiconductor patterns SP1, SP2, and SP3 may include crystalline silicon. Each of the first to third semiconductor patterns SP1, SP2, and SP3 may be a nanosheet. For example, the lower channel patterns LCH may further include at least one semiconductor pattern stacked spaced apart from the first semiconductor pattern SP1. The first semiconductor pattern SP1 may be a lowermost semiconductor pattern.

The lower source/drain patterns LSD may be provided on the lower active region LAR. Each of the lower source/drain patterns LSD may be an epitaxial pattern formed in a selective epitaxial growth (SEG) process. For example, the lower source/drain pattern LSD may have a higher upper surface than the third semiconductor pattern SP3 of the lower channel pattern LCH.

The lower source/drain pattern LSD may be doped with an impurity to have a first conductive type. The first conductive type may be an N-type or a P-type. In some implementations of this disclosure, the first conductive type may be an N-type. The lower source/drain patterns LSD may include silicon (Si) and/or silicon-germanium (SiGe).

The first seed layer SDL1 may be provided on the lower channel pattern LCH. The first seed layer SDL1 may vertically overlap the lower channel pattern LCH. The first seed layer SDL1 may include one of silicon (Si), germanium (Ge) and silicon-germanium (SiGe). For example, the first seed layer SDL1 may include silicon (Si). For another example, the first seed layer SDL1 may be omitted.

A first interlayer insulating layer 110 may be provided on the lower source/drain patterns LSD. The first interlayer insulating layer 110 may cover the lower source/drain patterns LSD. The first interlayer insulating layer 110 may include an insulating material.

A lower active contact LAC may be provided under the lower source/drain pattern LSD. The lower active contact LAC may be electrically connected to the lower source/drain pattern LSD. The lower active contact LAC may vertically extend from the lower source/drain pattern LSD. The lower active contact LAC may include a metal selected from the group consisting of copper (Cu), aluminum (Al), ruthenium (Ru), cobalt (Co), tungsten (W), molybdenum (Mo) and a combination thereof.

The upper active region UAR may be provided on the first interlayer insulating layer 110. The upper active region UAR may include upper channel patterns UCH and upper source/drain patterns USD. The upper channel patterns UCH may respectively vertically overlap the lower channel patterns LCH. The upper source/drain patterns USD may respectively vertically overlap the lower source/drain patterns LSD. The upper channel pattern UCH may be interposed between a pair of upper source/drain patterns USD. The upper channel pattern UCH may connect the pair of upper source/drain patterns USD with each other.

The upper channel pattern UCH may include a fourth semiconductor pattern SP4, a fifth semiconductor pattern SP5, and a sixth semiconductor pattern SP6 stacked spaced apart from each other. The fourth to sixth semiconductor patterns SP4, SP5 and SP6 of the upper channel pattern UCH may include the same semiconductor material as the first to third semiconductor patterns SP1, SP2, and SP3 of the lower channel pattern LCH described above. Each of the fourth to sixth semiconductor patterns SP4, SP5 and SP6 may be a nanosheet. For example, the upper channel pattern UCH may further include at least one semiconductor pattern stacked spaced apart from the sixth semiconductor pattern SP6.

At least one dummy channel pattern DSP may be interposed between the lower channel pattern LCH and the upper channel pattern UCH thereon. The dummy channel pattern DSP may be spaced apart from the upper source/drain patterns USD. In some implementations of this disclosure, the dummy channel pattern DSP may be spaced apart from the lower source/drain patterns LSD. That is, the dummy channel pattern DSP may not be connected to any source/drain pattern. The dummy channel pattern DSP may include a semiconductor material such as silicon (Si), germanium (Ge) or silicon-germanium (SiGe), or a silicon-based insulating material such as a silicon oxide layer or a silicon nitride layer. In some implementations of this disclosure, the dummy channel pattern DSP may include the silicon-based insulating material.

A second seed layer SDL2 may be interposed between the dummy channel pattern DSP and the upper channel pattern UCH. The second seed layer SDL2 may be provided under the upper channel pattern UCH. The second seed layer SDL2 may vertically overlap the upper channel pattern UCH. The second seed layer SDL2 may include one of silicon (Si), germanium (Ge) and silicon-germanium (SiGe). For example, the second seed layer SDL2 may include silicon (Si). For another example, the second seed layer SDL2 may be omitted.

The upper source/drain patterns USD may be provided on an upper surface of the first interlayer insulating layer 110. Each of the upper source/drain patterns USD may be an epitaxial pattern formed in a selective epitaxial growth (SEG) process. For example, the upper source/drain pattern USD may have a higher upper surface than the sixth semiconductor pattern SP6 of the upper channel pattern UCH.

The upper source/drain patterns USD may be doped with an impurity to have a second conductive type. The second conductive type may be different from the first conductive type of the lower source/drain pattern LSD. The second conductive type may be a P-type. The upper source/drain patterns USD may include silicon (Si) and/or silicon-germanium (SiGe).

The first interlayer insulating layer 110 may cover the upper source/drain pattern USD by, for example, extending on or over a bottom surface of the upper source/drain pattern USD. The first interlayer insulating layer 110 on the lower source/drain pattern LSD and the first interlayer insulating layer 110 on the upper source/drain pattern USD may be respectively formed in different processes and may not be simultaneously formed.

A plurality of gate electrodes GE may be provided on the single height cell SHC. Specifically, the gate electrode GE may be provided on the stacked lower and upper channel patterns LCH and UCH (see FIG. 4C). In a plan view, the gate electrode GE may have a form of a bar extending in the first direction D1. The gate electrode GE may vertically overlap the stacked lower and upper channel patterns LCH and UCH.

The gate electrode GE may be provided on an upper surface, a bottom surface and both sidewalls of each of the first to sixth semiconductor patterns SP1 to SP6. The transistor according to some implementations may be a three-dimensional field effect transistor (for example, MBCFET or GAAFET) in which the gate electrode GE three-dimensionally surrounds the channel thereof.

The gate electrode GE may extend from the lower active region LAR to the upper active region UAR in a vertical direction (for example, the third direction D3). The gate electrode GE may extend from an upper surface of the element isolation layer 107, to be described later, to a gate capping pattern GP, to be described later, in the vertical direction (that is, the third direction D3). The gate electrode GE may include the bottom tier of the front end of line (FEOL) layer, that is, a lower gate electrode LGE provided in the lower active region LAR, and the top tier of the front end of line (FEOL) layer, that is, an upper gate electrode UGE provided in the upper active region UAR.

The lower gate electrode LGE may be provided on an upper surface, a bottom surface and both sidewalls of each of the first to third semiconductor patterns SP1 to SP3. The upper gate electrode UGE may be provided on an upper surface, a bottom surface and both sidewalls of each of the fourth to sixth semiconductor patterns SP4 to SP6. The lower gate electrode LGE and the upper gate electrode UGE may vertically overlap each other to be connected to each other. The gate electrode GE may be a common gate electrode in which the lower gate electrode LGE on the lower channel pattern LCH and the upper gate electrode UGE on the upper channel pattern UCH are connected to each other. In another example, the lower gate electrode LGE and the upper gate electrode UGE may be separated from each other by an insulating material.

The lower gate electrode LGE may include a first inner electrode PO1 under a bottom surface of the first semiconductor pattern SP1, a second inner electrode PO2 interposed between the first semiconductor pattern SP1 and the second semiconductor pattern SP2, a third inner electrode PO3 interposed between the second semiconductor pattern SP2 and the third semiconductor pattern SP3, and a fourth inner electrode PO4 interposed between the third semiconductor pattern SP3 and the dummy channel pattern DSP (or the first seed layer SDL1).

The upper gate electrode UGE may include a fifth inner electrode PO5 interposed between the dummy channel patterns DSP (or the second seed layer SDL2) and the fourth semiconductor pattern SP4, a sixth inner electrode PO6 interposed between the fourth semiconductor pattern SP4 and the fifth semiconductor pattern SP5, a seventh inner electrode PO7 interposed between the fifth semiconductor pattern SP5 and the sixth semiconductor pattern SP6, and an outer electrode PO8 on the sixth semiconductor pattern SP6.

The lower gate electrode LGE may include a first work-function metal pattern on the first to third semiconductor patterns SP1, SP2, and SP3. The upper gate electrode UGE may include a second work-function metal pattern on the fourth to sixth semiconductor patterns SP4, SP5 and SP6. For example, each of the first and second work-function metal patterns may include nitrogen (N) and at least one metal selected from the group consisting of titanium (Ti), tantalum (Ta), aluminum (Al), tungsten (W), molybdenum (Mo) and a combination thereof. The first and second work-function metal patterns may have different work-functions. The gate electrode GE may include a low-resistance metal (for example, at least one of tungsten (W), ruthenium (Ru), aluminum (Al), titanium (Ti) or tantalum (Ta)) on the first and second work-function metal patterns. For example, the outer electrode PO8 may include the low-resistance metal as well as the second work-function metal pattern.

A gate insulating layer GI may be interposed between the gate electrode GE and the first to sixth semiconductor patterns SP1 to SP6. The gate insulating layer GI may include a silicon oxide layer, a silicon oxynitride layer, and/or a high dielectric layer. According to some implementations of this disclosure, the gate insulating layer GI may include a silicon oxide layer directly covering surfaces of the first to sixth semiconductor patterns SP1 to SP6 and the high dielectric layer on the silicon oxide layer. The gate insulating layer GI may include a multi-layer of the silicon oxide layer and the high dielectric layer.

The high dielectric layer may include a high dielectric material having a higher dielectric constant than a silicon oxide layer. For example, the high dielectric material may include at least one of hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, or lead zinc niobate.

A pair of gate spacers GS may be respectively disposed on both sidewalls of the gate electrode GE. Referring to FIG. 4A, a pair of gate spacers GS may be respectively disposed on both sidewalls of the outer electrode PO8. The gate spacers GS may extend along the gate electrode GE in the first direction D1. Upper surfaces of the gate spacers GS may be higher than an upper surface of the gate electrode GE. The upper surfaces of the gate spacers GS may be coplanar with an upper surface of the gate capping pattern GP. The gate spacers GS may include at least one of SiCN, SiCON, or SiN. As another example, the gate spacers GS may include a multi-layer composed of at least two of SiCN, SiCON, or SiN.

The gate capping pattern GP may be provided on the upper surface of the gate electrode GE. The gate capping pattern GP may extend along the gate electrode GE in the first direction D1. For example, the gate capping pattern GP may include at least one of SiON, SiCN, SiCON, or SiN.

A second interlayer insulating layer 120 may be provided on the gate capping pattern GP. An upper surface of the second interlayer insulating layer 120 may be coplanar with an upper surface of each of upper active contacts UAC, to be described later. The second interlayer insulating layer 120 may include an insulating material.

The upper active contacts UAC may be formed extending through the second interlayer insulating layer 120 to be electrically connected to the upper source/drain patterns USD. The upper active contacts UAC may be connected to the upper source/drain pattern USD. For example, the upper active contact UAC may be formed of metal selected from the group consisting of copper (Cu), aluminum (Al), ruthenium (Ru), cobalt (Co), tungsten (W), molybdenum (Mo) and a combination thereof.

An upper gate contact UGC extending through the second interlayer insulating layer 120 and the gate capping pattern GP to be electrically connected to the upper gate electrode UGE may be provided. The upper gate contact UGC may be connected to the upper gate electrode UGE. For example, the upper gate contact UGC may include metal selected from the group consisting of copper (Cu), aluminum (Al), ruthenium (Ru), cobalt (Co), tungsten (W), molybdenum (Mo) and a combination thereof.

The cutting pattern CTP may penetrate the gate electrode GE. The gate electrode GE may be separated from another gate electrode GE adjacent thereto in the first direction D1 by the cutting pattern CTP. The cutting pattern CTP may have a form of a bar or a line extending in the second direction D2. For example, referring to FIG. 4C, a pair of cutting patterns CTP may be respectively provided on both ends of the gate electrode GE.

The cutting pattern CTP may include a liner layer LIL and a buried pattern FIL on the liner layer LIL. Each of the liner layer LIL and the buried pattern FIL may include an insulating material such as a silicon oxide layer, a silicon nitride layer, or a combination thereof. In another example, the buried pattern FIL may include a metal material, and for example, may be formed of metal selected from the group consisting of copper (Cu), aluminum (Al), ruthenium (Ru), cobalt (Co), tungsten (W), molybdenum (Mo) and a combination thereof.

A third interlayer insulating layer 130 may be provided on the second interlayer insulating layer 120. A first metal layer M1 may be provided in the third interlayer insulating layer 130. The first metal layer M1 may include upper lines UMI. The first metal layer M1 may further include an upper via UVI. The upper via UVI may electrically connect the upper line UMI to the upper active contact UAC or the upper gate contact UGC. Each of the upper lines UMI and the upper via UVI may include metal selected from the group consisting of copper (Cu), aluminum (Al), ruthenium (Ru), cobalt (Co), tungsten (W), molybdenum (Mo) and a combination thereof.

Additional metal layers (for example, M2, M3, M4, and the like) may be stacked on the first metal layer M1. The first metal layer M1 and the metal layers (for example, M2, M3, M4 and the like) on the first metal layer M1 may constitute a back end of line (BEOL) layer of the semiconductor device. The metal layers (for example, M2, M3, M4 and the like) on the first metal layer M1 may include routing lines for connecting the logic cells to each other.

A first lower interlayer insulating layer 200 may be provided under the element isolation layer 107. A second lower interlayer insulating layer 210 may be provided under the first lower interlayer insulating layer 200. A backside metal layer BSM may be provided in the second lower interlayer insulating layer 210. The backside metal layer BSM may include lower lines LMI. The backside metal layer BSM may further include a lower via LVI. The lower via LVI may electrically connect any one among a lower gate contact LGC and the lower active contact LAC to the lower line LMI. Each of the lower line LMI and the lower via LVI may include metal selected from the group consisting of copper (Cu), aluminum (Al), ruthenium (Ru), cobalt (Co), tungsten (W), molybdenum (Mo) and a combination thereof.

Additional lower metal layers may be stacked under the backside metal layer BSM. According to some implementations of this disclosure, the lower metal layers may include a power transmission network. The power transmission network may include a line network for applying the source voltage VSS and the drain voltage VDD to the backside metal layer BSM.

The source voltage VSS and the drain voltage VDD may be applied to the backside metal layer BSM through the power transmission network. Referring back to FIG. 4A, any one of the source voltage VSS and the drain voltage VDD may be applied to the lower source/drain pattern LSD through the lower line LMI, the lower via LVI and the lower active contact LAC. The other of the source voltage VSS and the drain voltage VDD may be applied from the backside metal layer BSM to the first metal layer M1 through a power tab cell. The voltage applied to the first metal layer M1 through the power tab cell may be applied to the upper source/drain pattern USD through the upper line UMI, the upper via UVI and the upper active contact UAC. The power tab cell may be interposed between the single height cells SHC adjacent to each other.

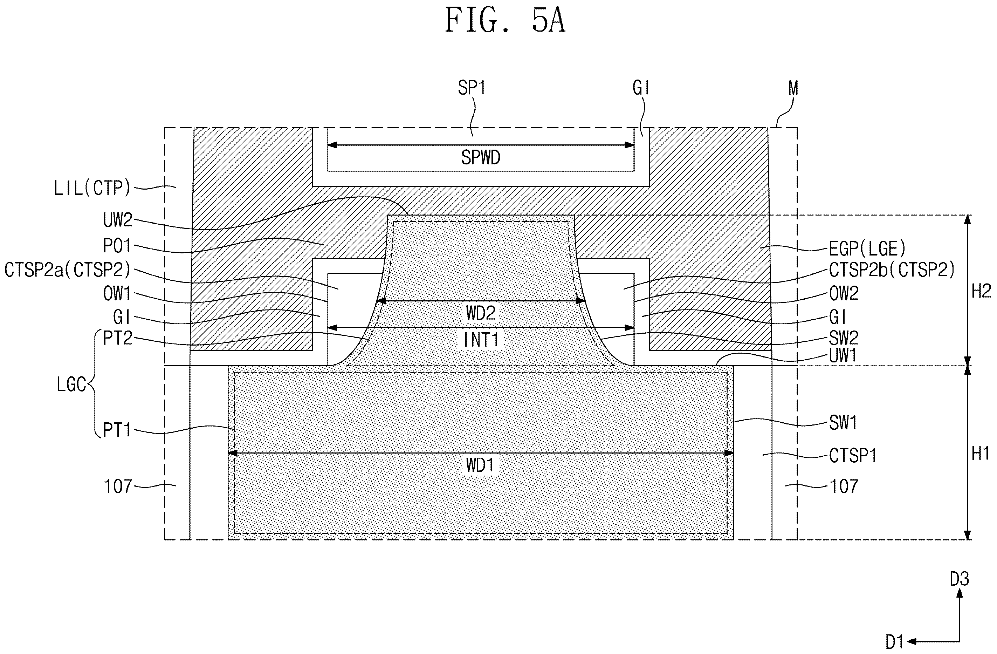

FIG. 5A is an enlarged view taken along region M of FIG. 4C. Hereinafter, referring to FIGS. 4C and 5A, the lower gate electrode LGE and the lower gate contact LGC according to some implementations of this disclosure will be described in more detail.

The lower gate electrode LGE may include the first inner electrode PO1 under the lower channel pattern LCH and an edge electrode EGP extending downwardly along a sidewall of the lower channel pattern LCH. The edge electrode EGP may be provided on both sides of the first inner electrode PO1. The edge electrode EGP may extend more downwardly than the first inner electrode PO1. Accordingly, a level of a bottom surface of the edge electrode EGP may be lower than a level of a bottom surface of the first inner electrode PO1. The bottom surface of the edge electrode EGP may be a bottom surface of the lower gate electrode LGE.

The lower gate contact LGC may be provided under the lower gate electrode LGE to be connected to the lower gate electrode LGE. The lower gate contact LGC may be electrically connected to the lower gate electrode LGE. The lower gate contact LGC may include a conductive material. For example, the lower gate contact LGC may include metal selected from the group consisting of copper (Cu), aluminum (Al), ruthenium (Ru), cobalt (Co), tungsten (W), molybdenum (Mo) and a combination thereof.

The lower gate contact LGC may include a first part PT1 and a second part PT2 on the first part PT1. The second part PT2 may vertically protrude from the first part PT1. The second part PT2 may be in direct contact with the lower gate electrode LGE. The second part PT2 may be connected to the first inner electrode PO1 of the lower gate electrode LGE. The first part PT1 may not horizontally overlap the lower gate electrode LGE, but the second part PT2 may horizontally overlap the lower gate electrode LGE. The second part PT2 may have a height of about 7 nm to about 15 nm, but implementations of this disclosure are not limited thereto. In a manufacturing method to be described later, the second part PT2 may have substantially the same height as a buffer layer BFL to be described later.

The first part PT1 may include a first upper surface UW1 extending in the first direction D1. The first part PT1 may include first upper surfaces UW1 spaced apart from each other in the first direction D1 with the second part PT2 therebetween. The first upper surface UW1 may face the lower gate electrode LGE. For example, the first upper surface UW1 may face a bottom surface of the lower gate electrode LGE. The first upper surface UW1 may have a lower level than the bottom surface of the lower gate electrode LGE. The gate insulating layer GI may be interposed between the first upper surface UW1 and the lower gate electrode LGE.

The second part PT2 may include a second upper surface UW2 extending in the first direction D1. The second upper surface UW2 of the second part PT2 may be an uppermost surface of the lower gate contact LGC. The second upper surface UW2 may be located at a higher level than the first upper surface UW1. The second upper surface UW2 may have a higher level than a bottom surface of the first inner electrode PO1 of the lower gate electrode LGE.

The first part PT1 may have a first width WD1 in the first direction D1. The second part PT2 may have a second width WD2 in the first direction D1. The first width WD1 may be greater than the second width WD2. A minimum value of the first width WD1 may be greater than a maximum value of the second width WD2. A ratio of the first width WD1 to the second width WD2 may be about 1.5 to about 5, but implementations of this disclosure are not limited thereto.

The second width WD2 of the second part PT2 may have a minimum value on the second upper surface UW2 of the second part PT2 and may increase from the second upper surface UW2 of the second part PT2 in a downward direction. The second width WD2 of the second part PT2 may have a maximum value on a boundary of the first part PT1 and the second part PT2. The maximum value of the second width WD2 may be the same as or smaller than a width SPWD in the first direction D1 of each of the first to third semiconductor patterns SP1, SP2, and SP3 of the lower channel pattern LCH.

The first part PT1 may include a first sidewall SW1, and the second part PT2 may include a second sidewall SW2. The first sidewall SW1 and the second sidewall SW2 may be offset in the first direction D1. In other words, the first sidewall SW1 and the second sidewall SW2 may not vertically overlap each other. The first sidewall SW1 and the second sidewall SW2 may be connected to each other by the first upper surface UW1.

The second sidewall SW2 may be spaced apart from the edge electrode EGP of the lower gate electrode LGE in the first direction D1. The second sidewall SW2 may be a concave curved surface. In other words, the second sidewall SW2 may have a concave profile which is recessed towards the inside of the second part PT2. Due to the concave profile of the second sidewall SW2, the second width WD2 of the second part PT2 may increase from the second upper surface UW2 in a downward direction.

A first contact spacer CTSP1 may be provided on the first sidewall SW1, and a second contact spacer CTSP2 may be provided on the second sidewall SW2. The second contact spacer CTSP2 may be interposed between the edge electrode EGP of the lower gate electrode LGE and the second sidewall SW2. The first contact spacer CTSP1 and the second contact spacer CTSP2 may be offset in the first direction D1. In other words, the first contact spacer CTSP1 and the second contact spacer CTSP2 may not be connected to each other. The first and second contact spacers CTSP1 and CTSP2 may include an insulating material. For example, the first and second contact spacers CTSP1 and CTSP2 may include at least one of SiCN, SiCON or SiN.

The gate insulating layer GI may be interposed between the second contact spacer CTSP2 and the lower gate electrode LGE. An upper surface of the second contact spacer CTSP2 may have a higher level than a bottom surface of the lower gate electrode LGE and may have a lower level than the second upper surface UW2 of the second part PT2. The second contact spacer CTSP2 may have a maximum width on the upper surface of the second contact spacer CTSP2 and may decrease from the upper surface in a downward direction to have a minimum width on a bottom surface of the second contact spacer CTSP2. The second contact spacer CTSP2 may include a sidewall in direct contact with the second part PT2, and the sidewall may have a convex profile corresponding to the concave profile of the second sidewall SW2 of the second part PT2.

The second contact spacer CTSP2 may include a first sidewall contact spacer CTSP2a on one sidewall (for example, the second sidewall SW2) of the second part PT2, and a second sidewall contact spacer CTSP2b on the other sidewall (for example, the second sidewall SW2) of the second part PT2. The one sidewall and the other sidewall of the second part PT2 may be opposed to each other in the first direction D1.

The first sidewall contact spacer CTSP2a may include a first outer wall OW1 adjacent to the edge electrode EGP of the lower gate electrode LGE. The second sidewall contact spacer CTSP2b may include a second outer wall OW2 adjacent to the edge electrode EGP of the lower gate electrode LGE. A distance INT1 in the first direction D1 between the first outer wall OW1 and the second outer wall OW2 may be substantially the same as a width SPWD of each of the first to third semiconductor patterns SP1, SP2, and SP3 of the lower channel pattern LCH.

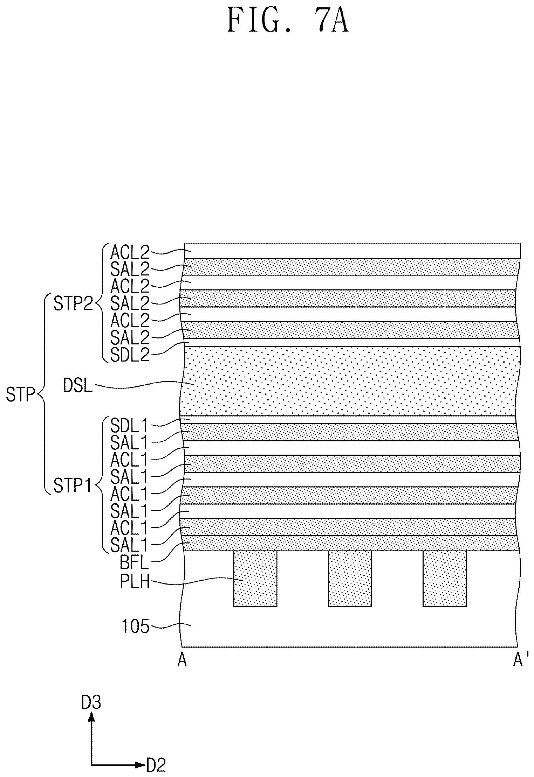

According to this disclosure, the lower gate contact LGC may include the first part PT1, and the second part PT2 vertically protruding from the first part PT1, and the second part PT2 may have a smaller width than the first part PT1. In other words, the lower gate contact LGC may have a part in which a width thereof changes rapidly. This rapid change of width occurs because, due to the buffer layer BFL formed in the manufacturing method to be described later (referring to FIGS. 7A, 7B, 8A, 8B, 9, 10A, 10B, 11, 12A, 12B, 13A, 13B, 14, 15A, 15B, 16A, 16B, and 17), a bottom surface of the edge electrode EGP is located at a lower level than a bottom surface of the first inner electrode PO1, and the lower gate contact LGC is formed so as to be connected to the first inner electrode PO1. More specifically, when the first and second sacrificial layers SAL1 and SAL2 are removed, the buffer layer BFL prevents the sacrificial contact pattern PLH from being etched. And as the buffer layer BFL is subsequently removed, the bottom surface having a step difference of the lower gate electrode LGE is exposed to form a lower gate contact LGC on the bottom surface.

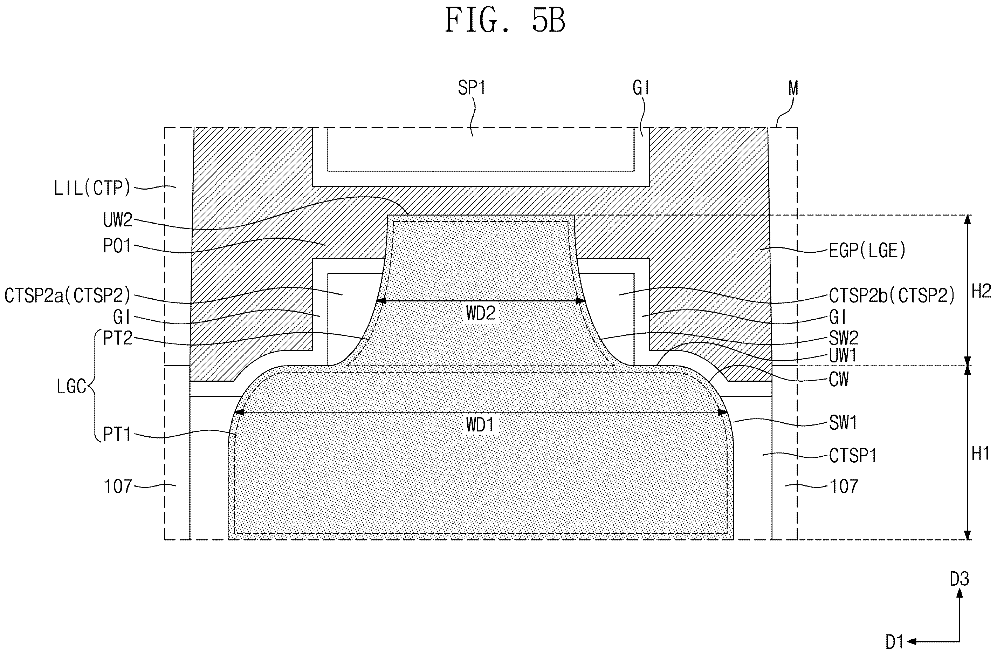

FIG. 5B is a diagram for describing a semiconductor device according to some other implementations of this disclosure. FIG. 5B is an enlarged view taken along region M of FIG. 4C. Hereinafter, duplicate technological features of what is described with reference to FIG. 5A will be omitted, and a difference will be described in detail.

Referring to FIG. 5B, the first upper surface UW1 of the first part PT1 of the lower gate contact LGC may have a higher level than a bottom surface of the lower gate electrode LGE. Accordingly, an upper portion of the first part PT1 may horizontally overlap the lower gate electrode LGE.

The first part PT1 of the lower gate contact LGC may have an edge, which is a curved surface. The first part PT1 may include a connection sidewall CW, which is a curved surface connecting the first sidewall SW1 and the first upper surface UW1. The connection sidewall CW of the first part PT1 may have a convex profile. Due to the connection sidewall CW, the first width WD1 of the first part PT1 may decrease in a direction getting closer to the boundary of the first part PT1 and the second part PT2.

An upper portion of the first contact spacer CTSP1 may have a greater width than a lower portion of the first contact spacer CTSP1. Due to the connection sidewall CW, the width of the first contact spacer CTSP1 may increase in a direction getting closer to the upper surface of the first contact spacer CTSP1. The upper portion of the first contact spacer CTSP1 may include a concave sidewall corresponding to the connection sidewall CW.

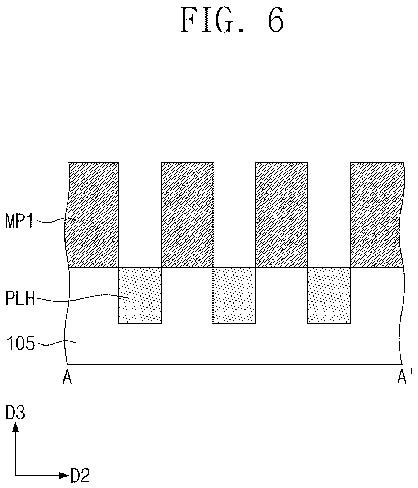

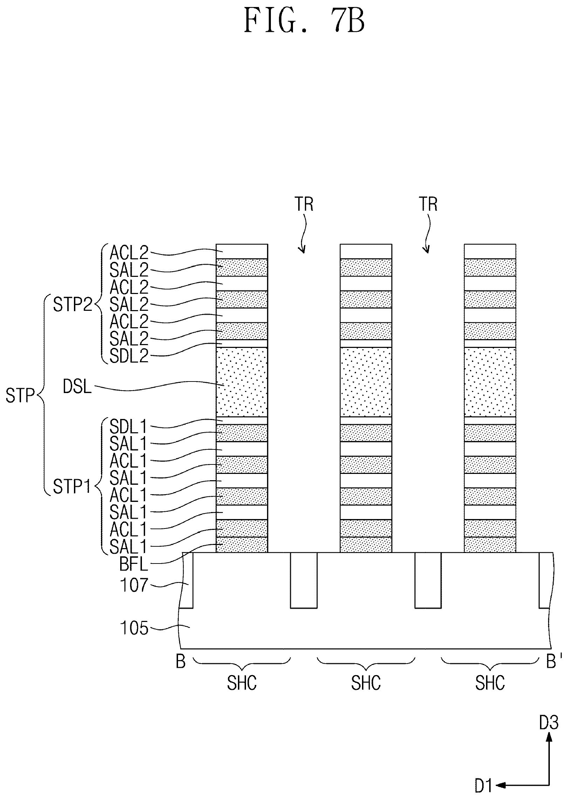

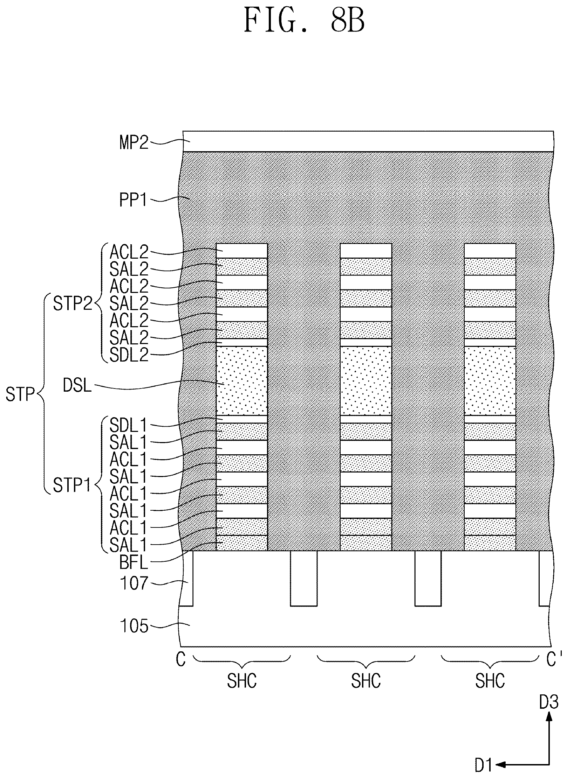

FIGS. 6, 7A, 7B, 8A, 8B, 9, 10A, 10B, 11, 12A, 12B, 13A, 13B, 14, 15A, 15B, 16A, 16B, and 17 are cross-sectional views for describing a method for manufacturing a semiconductor device according to implementations of this disclosure. Specifically, FIGS. 6, 7A, 8A, 9, 10A, 11, 12A, 13A, 14, 15A, and 16A are cross-sectional views corresponding to line A-A' of FIG. 3. FIG. 7B is a cross-sectional view taken along line B-B' of FIG. 3. FIGS. 8B, 10B, 12B, 13B, 15B, 16B and 17 are cross-sectional views corresponding to line C-C' of FIG. 3. Hereinafter, a method for manufacturing a three-dimensional semiconductor device according to FIGS. 3, 4A, 4B, 4C, 5A, and 5B will be described with reference to FIGS. 6, 7A, 7B, 8A, 8B, 9, 10A, 10B, 11, 12A, 12B, 13A, 13B, 14, 15A, 15B, 16A, 16B, and 17. For simplification of description, duplicate description of what is described above will be omitted.

Referring to FIG. 6, the semiconductor substrate 105 may be provided. The semiconductor substrate 105 may include any one of silicon (Si), germanium (Ge) and silicon-germanium (SiGe). For example, the semiconductor substrate 105 may be a single-crystalline silicon wafer.

Sacrificial contact patterns PLH may be formed in the semiconductor substrate 105 in contact forms. Forming the sacrificial contact patterns PLH may include forming a first hard mask pattern MP1 on the semiconductor substrate 105, forming a recess in the semiconductor substrate 105 by performing an etching process by using the first hard mask pattern MP1 as a mask, and performing an epitaxial growth process in the recess. The sacrificial contact patterns PLH may be arranged along the second direction D2. The sacrificial contact patterns PLH may include a material having etching selectivity with the semiconductor substrate 105, for example, silicon-germanium (SiGe).

Referring to FIGS. 7A and 7B, the buffer layer BFL may be formed on the semiconductor substrate 105 and the sacrificial contact patterns PLH. The buffer layer BFL may cover upper surfaces of the sacrificial contact patterns PLH. In other words, the sacrificial contact patterns PLH may not be exposed due to the buffer layer BFL. The buffer layer BFL may have a height of about 7 nm to about 15 nm, but implementations are not limited thereto. Preferably, the buffer layer BFL may have a height of about 12 nm. The buffer layer BFL may include a material having etching selectivity with each of the sacrificial contact patterns PLH. For example, the buffer layer BFL may include silicon (Si), but implementations are not limited thereto.

First sacrificial layers SAL1 and first active layers ACL1 may be alternately stacked on the buffer layer BFL. The first sacrificial layers SAL1 may include one of silicon (Si), germanium (Ge), and silicon-germanium (SiGe), and the first active layers ACL1 may include another one of silicon (Si), germanium (Ge), and silicon-germanium (SiGe). For example, the first sacrificial layers SAL1 may include silicon-germanium (SiGe), and the first active layers ACL1 may include silicon (Si). Each of the first sacrificial layers SAL1 may have a germanium (Ge) concentration of about 10 at% to about 30 at%.

The first seed layer SDL1 may be formed on an uppermost first sacrificial layer SAL1. The first seed layer SDL1 may include the same material as the first active layer ACL1.

A separation layer DSL may be formed on the first seed layer SDL1. According to some implementations of this disclosure, the separation layer DSL may have a greater thickness than the first sacrificial layer SAL1. The separation layer DSL may include silicon (Si) or silicon-germanium (SiGe). When the separation layer DSL includes silicon-germanium (SiGe), the separation layer DSL may have a greater germanium (Ge) concentration than the first sacrificial layer SAL1. For example, the separation layer DSL may have a germanium (Ge) concentration of about 40 at% to about 90 at%.

The second seed layer SDL2 may be formed on the separation layer DSL. The second seed layer SDL2 may include the same material as the first active layer ACL1. Second sacrificial layers SAL2 and second active layers ACL2 may be alternately stacked on the second seed layer SDL2. Each of the second sacrificial layers SAL2 may include the same material as the first sacrificial layer SAL1, and each of the second active layers ACL2 may include the same material as the first active layer ACL1. The separation layer DSL may be interposed between the first seed layer SDL1 and the second seed layer SDL2.

A stack pattern STP may be formed by patterning the first and second sacrificial layers SAL1 and SAL2, the first and second active layers ACL1 and ACL2, the first and second seed layers SDL1 and SDL2, and the separation layer DSL which are stacked. Forming the stack pattern STP may include forming a hard mask pattern on an uppermost second active layer ACL2, and etching the stacked layers SAL1, SAL2, ACL1, ACL2, SDL1, SDL2 and DSL on the semiconductor substrate 105 by using the hard mask pattern as an etching mask. During forming the stack pattern STP, a trench TR defining the single height cell SHC may be formed by patterning an upper portion of the semiconductor substrate 105. The stack pattern STP may have a form of a bar or a line extending in the second direction D2.

The stack pattern STP may include a lower stack pattern STP1 on the buffer layer BFL, an upper stack pattern STP2 on the lower stack pattern STP1, and the separation layer DSL between the lower and upper stack patterns STP1 and STP2. The lower stack pattern STP1 may include the first sacrificial layers SAL1 and the first active layers ACL1 alternately stacked, and the first seed layer SDL1. The upper stack pattern STP2 may include the second seed layer SDL2, and the second sacrificial layers SAL2 and the second active layers ACL2 alternately stacked on the second seed layer SDL2.

The element isolation layer 107 filling a lower portion of the trench TR may be formed on the semiconductor substrate 105. Specifically, an insulating layer may be formed covering the stack patterns STP on the entire surface of the semiconductor substrate 105. The element isolation layer 107 may be formed by recessing the insulating layer until the stack patterns STP are exposed. An upper surface of the element isolation layer 107 may be coplanar with an upper surface of the semiconductor substrate 105.

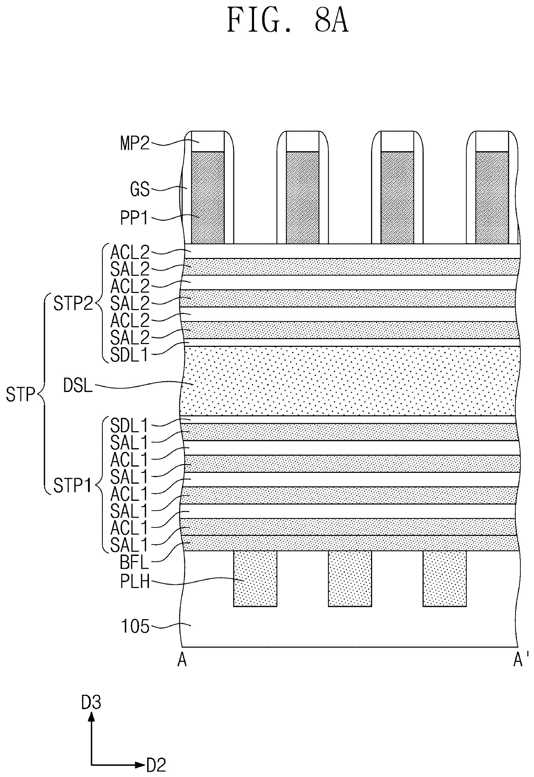

Referring to FIGS. 8A and 8B, a plurality of first sacrificial patterns PP1 may be formed crossing the stack pattern STP. Each of the first sacrificial patterns PP1 may be formed in a form of a line extending in the first direction D1. Specifically, forming the first sacrificial pattern PP1 may include forming a sacrificial layer on the entire surface of the semiconductor substrate 105, forming a second hard mask pattern MP2 on the sacrificial layer, and patterning the sacrificial layer by using the second hard mask pattern MP2 as an etching mask. The sacrificial layer may include amorphous silicon and/or polysilicon.

A pair of gate spacers GS may be respectively formed on both sidewalls of the first sacrificial pattern PP1. Specifically, a spacer layer may be conformally formed on the entire surface of the semiconductor substrate 105. The spacer layer may cover the first sacrificial pattern PP1 and the second hard mask pattern MP2. For example, the spacer layer may include at least one of SiCN, SiCON, or SiN. The gate spacers GS may be formed by anisotropically etching the spacer layer.

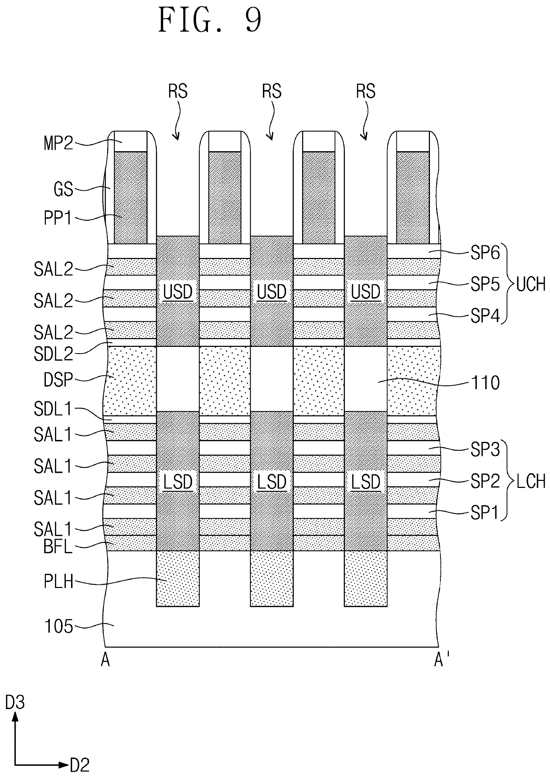

Referring to FIG. 9, an etching process may be performed on the stack pattern STP by using the gate spacers GS and the second hard mask pattern MP2 as etching masks. A recess RS may be formed between the first sacrificial patterns PP1 adjacent to each other in the etching process. The stack pattern STP may be formed in a form of a vertical rod by the recess RS.

The recess RS may expose the sacrificial contact pattern PLH. In other words, the recess RS may overlap the sacrificial contact pattern PLH. According to some implementations of this disclosure, when the separation layer DSL includes silicon-germanium (SiGe), the separation layer DSL may be replaced with a silicon-based insulating material to form the dummy channel pattern DSP. A silicon-based insulating material (for example, silicon nitride) may fill a region in which the separation layer DSL exposed by the recess RS is selectively removed.

The lower source/drain pattern LSD may be formed on the sacrificial contact pattern PLH in the recess RS. Specifically, the lower source/drain pattern LSD may be formed by performing a first SEG process using a sidewall of the lower stack pattern STP1 exposed by the recess RS as a seed layer. The lower source/drain pattern LSD may be grown by using the first active layers ACL1 exposed by the recess RS as a seed. For example, the first SEG process may include a chemical vapor deposition (CVD) process or a molecular beam epitaxy (MBE) process.

During the first SEG process, an impurity may be in-situ injected into the lower source/drain pattern LSD. In another example, after the lower source/drain pattern LSD is formed, the impurity may be injected into the lower source/drain pattern LSD. The lower source/drain pattern LSD may be doped so as to have the first conductive type (for example, an N-type).

The first active layers ACL1 interposed between a pair of lower source/drain patterns LSD adjacent to each other in the second direction D2 may constitute the lower channel pattern LCH. That is, the first to third semiconductor patterns SP1, SP2, and SP3 of the lower channel pattern LCH may be formed from the first active layers ACL1. The lower channel patterns LCH and the lower source/drain patterns LSD may constitute the lower active region LAR, which is the bottom tier of the three-dimensional device.

The lower source/drain pattern LSD may be formed so as to completely fill a space between a pair of lower channel patterns LCH. In other words, the first SEG process may be performed for a sufficient time until the lower source/drain pattern LSD fills the space between the pair of lower channel patterns LCH to connect the same.

The first interlayer insulating layer 110 may be formed so as to cover the lower source/drain pattern LSD. For example, before forming the first interlayer insulating layer 110, an insulating layer conformally covering the lower source/drain pattern LSD may be further formed.

The first interlayer insulating layer 110 may cover a sidewall of the upper stack pattern STP2 in the recess RS. Thereafter, the sidewall of the upper stack pattern STP2 may be exposed again in the recess RS by removing an upper portion of the first interlayer insulating layer 110. The upper source/drain pattern USD may be formed on the exposed sidewall of the upper stack pattern STP2. Specifically, the upper source/drain pattern USD may be formed by performing a second SEG process using the sidewall of the upper stack pattern STP2 exposed by the recess RS as a seed layer. The upper source/drain pattern USD may be grown by using the second active layers ACL2 exposed by the recess RS as a seed. The upper source/drain pattern USD may be doped so as to have the second conductive type (for example, a P-type) different from the first conductive type.

The second active layers ACL2 interposed between a pair of upper source/drain patterns USD may constitute the upper channel pattern UCH. That is, the fourth to sixth semiconductor patterns SP4, SP5 and SP6 of the upper channel pattern UCH may be formed from the second active layers ACL2. The upper channel patterns UCH and the upper source/drain patterns USD may constitute the upper active region UAR, which is the top tier of the three-dimensional device. The second SEG process may be performed for a sufficient time such that the upper source/drain pattern USD completely fills the space between the pair of upper channel patterns UCH.

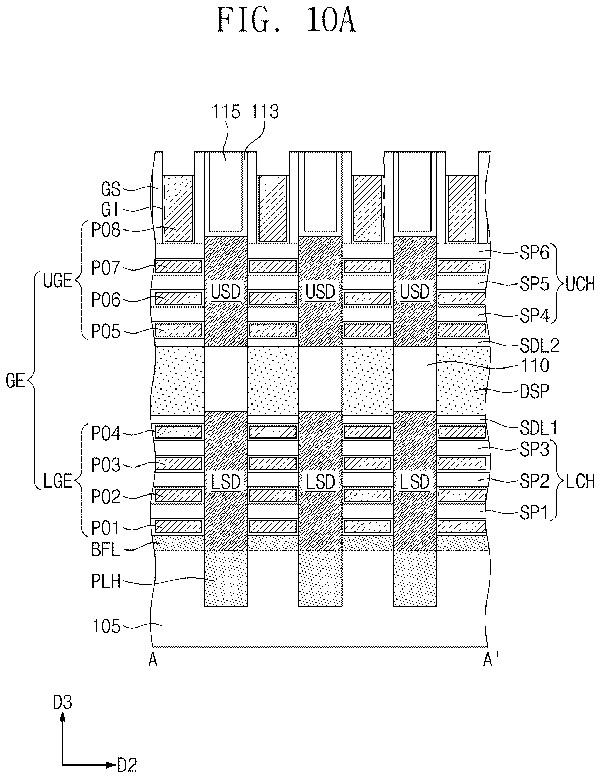

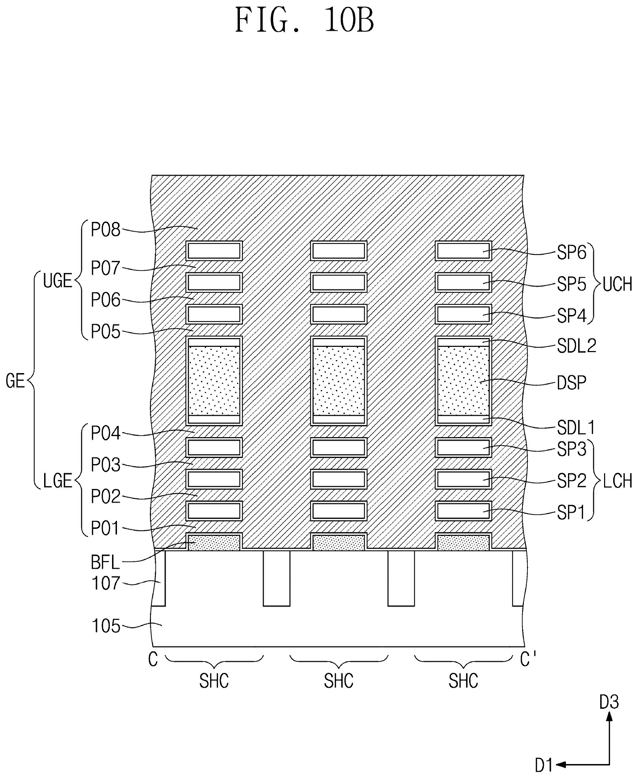

Referring to FIGS. 10A and 10B, a thin first insulating layer 113 may be conformally formed on the upper source/drain pattern USD. A first buried insulating layer 115 that fills the recess RS may be formed on the first insulating layer 113. For example, the first buried insulating layer 115 may include a silicon oxide layer.

The first buried insulating layer 115 may be planarized until an upper surface of the first sacrificial pattern PP1 is exposed. Planarization of the first buried insulating layer 115 may be performed by using a chemical mechanical polishing (CMP) process or an etch back process. During the planarization process, the second hard mask pattern MP2 on the first sacrificial pattern PP1 may be completely removed. As a result, an upper surface of the first buried insulating layer 115 may be coplanar with an upper surface of the first sacrificial pattern PP1 and upper surfaces of the gate spacers GS.

The exposed first sacrificial pattern PP1 may be selectively removed. Removing the first sacrificial pattern PP1 may include wet etching using etchant that selectively etches polysilicon. The first and second sacrificial layers SAL1 and SAL2 may be exposed by removing the first sacrificial pattern PP1.

The first to sixth semiconductor patterns SP1 to SP6 and the dummy channel pattern DSP may be left and only the first and second sacrificial layers SAL1 and SAL2 may be removed by performing an etching process of selectively etching the first and second sacrificial layers SAL1 and SAL2. The etching process may have a high etch rate with respect to silicon-germanium. For example, the etching process may have a high etch rate with respect to silicon-germanium having a germanium concentration greater than about 10 at%.

The sacrificial contact patterns PLH may not be etched during the etching process of removing the first and second sacrificial layers SAL1 and SAL2. As shown in FIGS. 8A and 9, since the buffer layer BFL completely covers upper surfaces of the sacrificial contact patterns PLH, the buffer layer BFL may protect the sacrificial contact patterns PLH from being damaged. In a case of omitting the buffer layer BFL, when a lowermost first sacrificial layer SAL1 is removed, the sacrificial contact patterns PLH may be exposed to be removed or damaged together.

The gate insulating layer GI may be conformally formed in a region in which the first sacrificial pattern PP1 and the first and second sacrificial layers SAL1 and SAL2 are removed. The gate insulating layer GI may surround each of the first to sixth semiconductor patterns SP1 to SP6. The gate insulating layer GI may cover both sidewalls and a bottom surface of the first seed layer SDL1, both sidewalls and an upper surface of the second seed layer SDL2, and both sidewalls of the dummy channel pattern DSP.

The gate electrode GE may be formed on the gate insulating layer GI. The lower gate electrode LGE may be formed on the gate insulating layer GI of the lower active region LAR, and the upper gate electrode UGE may be formed on the gate insulating layer GI of the upper active region UAR.

Forming the lower gate electrode LGE may include forming the first inner electrode PO1 between the buffer layer BFL and the first semiconductor pattern SP1, the second and third inner electrodes PO2 and PO3 between the first to third semiconductor patterns SP1, SP2, and SP3, and the fourth inner electrode PO4 between the third semiconductor pattern SP3 and the first seed layer SDL1.

Forming the upper gate electrode UGE may include forming the fifth inner electrode PO5 between the second seed layer SDL2 and the fourth semiconductor pattern SP4, the sixth and seventh inner electrodes PO6 and PO7 between the fourth to sixth semiconductor patterns SP4, SP5 and SP6, and the outer electrode PO8 on the sixth semiconductor pattern SP6.

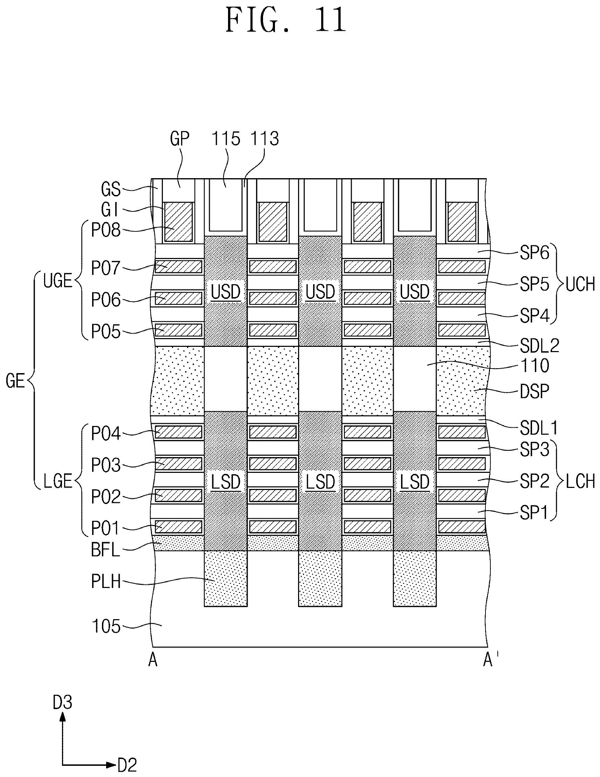

Referring to FIG. 11, the upper gate electrode UGE may be recessed to reduce a height thereof. The gate capping pattern GP may be formed on the recessed upper gate electrode UGE. A planarization process may be performed on the gate capping pattern GP such that an upper surface of the gate capping pattern GP is coplanar with an upper surface of the first buried insulating layer 115.

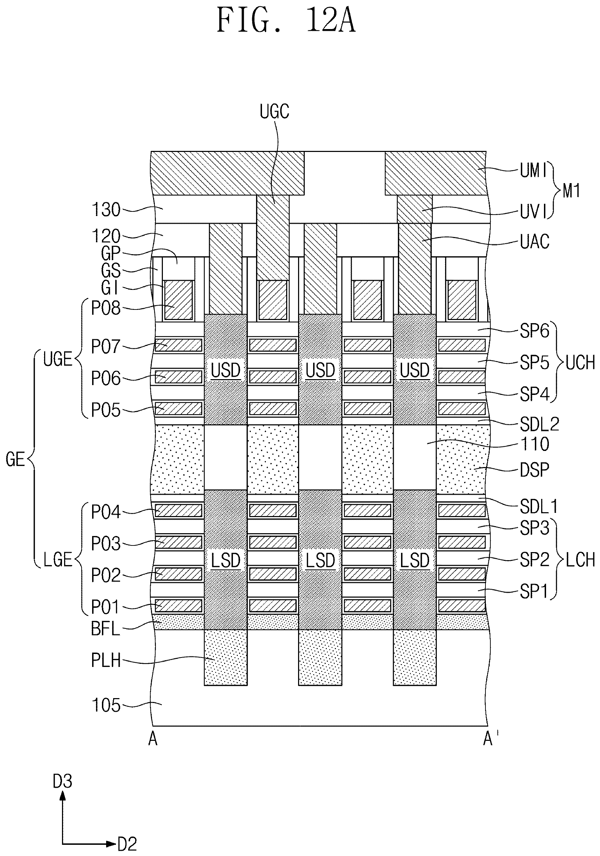

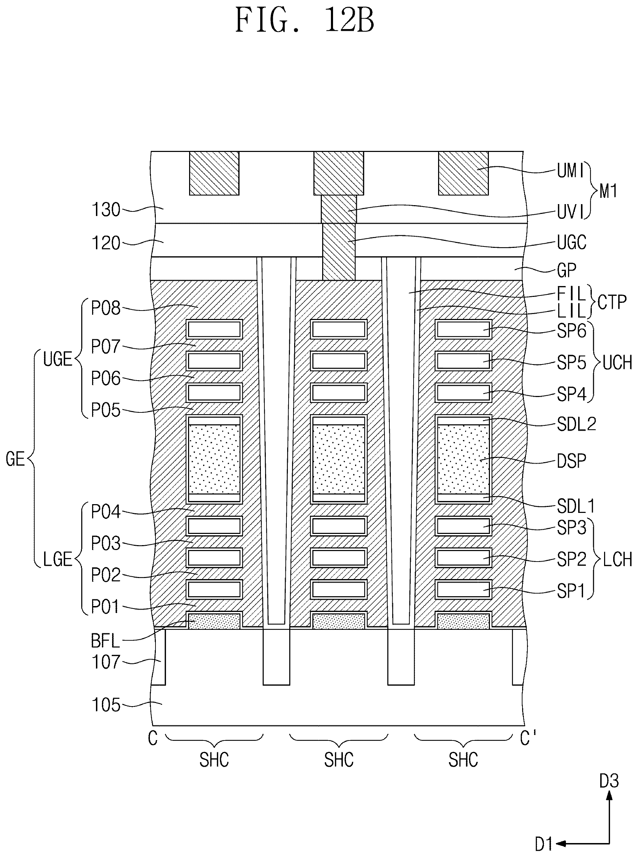

Referring to FIGS. 12A and 12B, the cutting pattern CTP may penetrate the gate capping pattern GP and the gate electrode GE to be formed. Forming the cutting pattern CTP may include forming a penetration via penetrating the gate capping pattern GP and the gate electrode GE by performing an etching process, conformally forming the liner layer LIL in the penetration via and forming the buried pattern FIL on the liner layer LIL. Each of the liner layer LIL and the buried pattern FIL may include an insulating material.

The second interlayer insulating layer 120 may be formed on the gate capping pattern GP. The upper active contacts UAC may be formed to penetrate the second interlayer insulating layer 120 to be respectively connected to the upper source/drain patterns USD. The upper gate contact UGC may be formed to penetrate the second interlayer insulating layer 120 and the gate capping pattern GP to be connected to the gate electrode GE. For example, each of the upper active contact UAC and the upper gate contact UGC may be formed of a metal selected from the group consisting of copper (Cu), aluminum (Al), ruthenium (Ru), cobalt (Co), tungsten (W), molybdenum (Mo) and a combination thereof.

The third interlayer insulating layer 130 may be formed so as to cover the second interlayer insulating layer 120. The first metal layer M1 including the upper lines UMI may be formed in the third interlayer insulating layer 130. The upper vias UVI may be formed to electrically connect the first metal layer M1 to the upper gate contacts UGC and the upper active contacts UAC. The back end of line (BEOL) layer including additional metal layers (for example, M2, M3, M4, and the like) may be formed on the first metal layer M1.

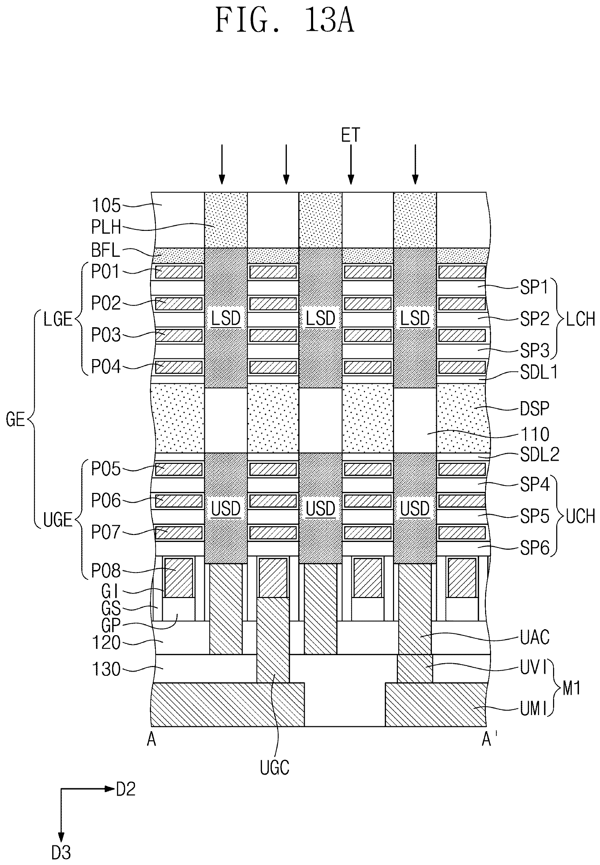

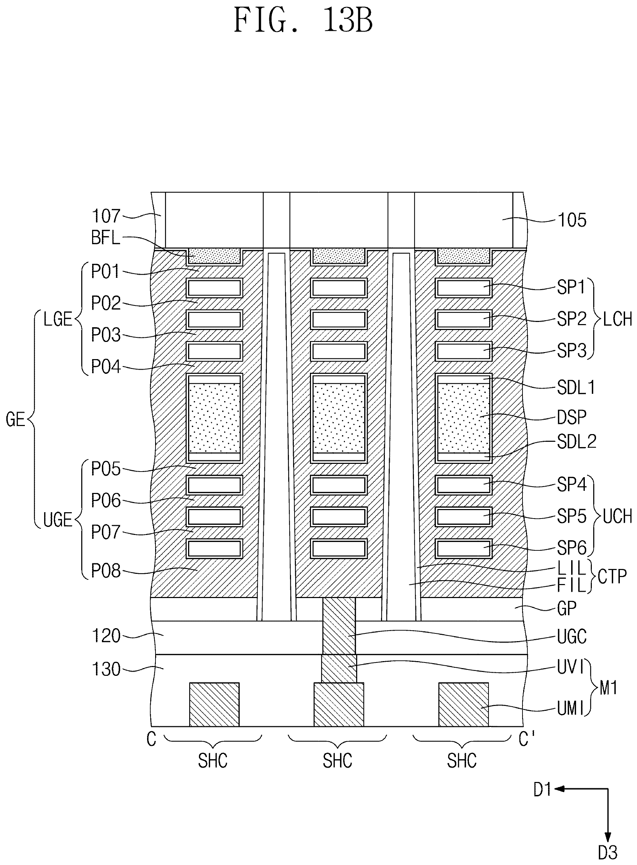

Referring to FIGS. 13A and 13B, the semiconductor substrate 105 may be turned over so as to expose a rear surface of the semiconductor substrate 105. A height of the semiconductor substrate 105 may be reduced by performing an etching process ET on the rear surface of the semiconductor substrate 105. A planarization process may be performed on the rear surface of the semiconductor substrate 105 until upper surfaces of the sacrificial contact patterns PLH are exposed. Upper surfaces of the element isolation layers 107 may be exposed in the planarization process.

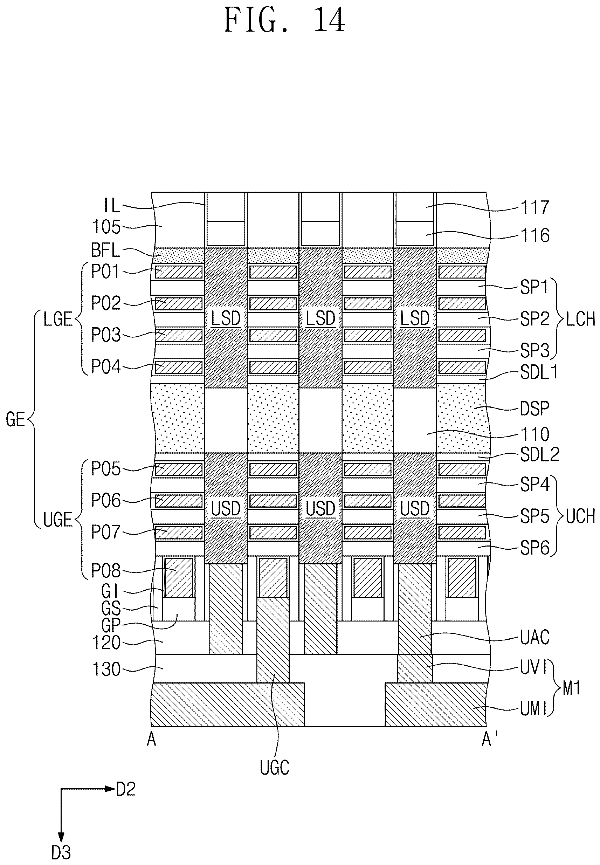

Referring to FIG. 14, the exposed sacrificial contact patterns PLH may be selectively removed to expose the bottom surface of the lower source/drain pattern LSD. A second insulating layer IL may be conformally formed on the bottom surface of the exposed lower source/drain pattern LSD and the side surface of the semiconductor substrate 105. A second buried insulating layer 116 and a third buried insulating layer 117 may be sequentially formed on the second insulating layer IL. Forming the second and third buried insulating layers 116 and 117 may include forming a buried layer on the second insulating layer IL, forming the second buried insulating layer 116 by etching the buried layer, forming another buried layer on the second buried insulating layer 116, and forming the third buried insulating layer 117 by etching the other buried layer.

Each of the second buried insulating layer 116 and the third buried insulating layer 117 may include an insulating material. For example, the second buried insulating layer 116 may include silicon oxide (SiOx), and the third buried insulating layer 117 may include silicon nitride (SiN).

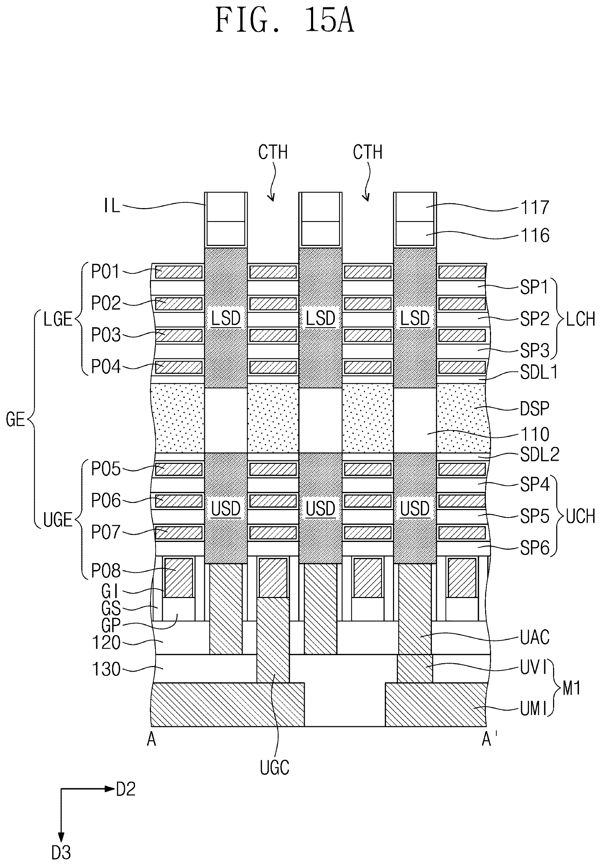

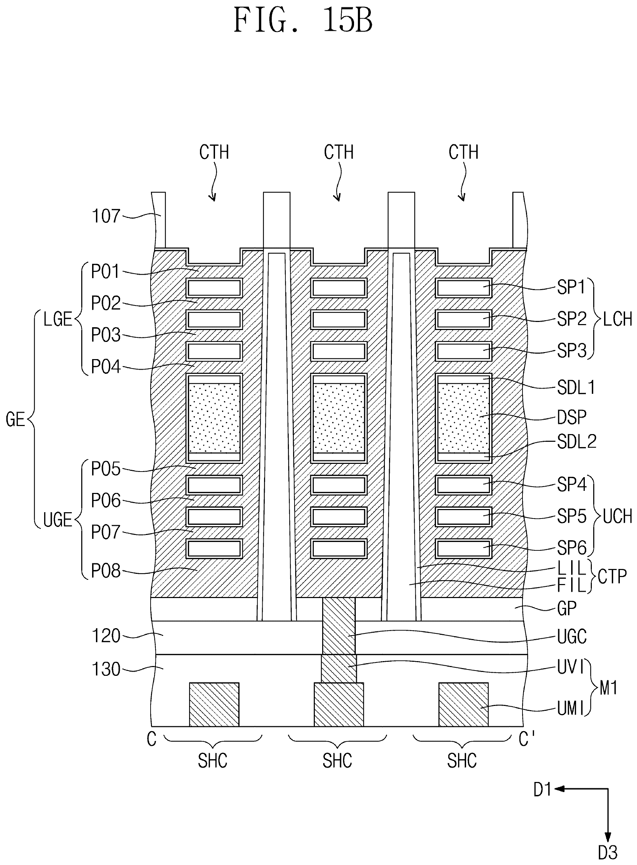

Referring to FIGS. 15A and 15B, contact holes CTH may be formed by removing the semiconductor substrate 105 and the buffer layer BFL. The bottom surface of the lower gate electrode LGE may be exposed by the contact holes CTH. The buffer layer BFL may be removed to expose a bottom surface having a step of the lower gate electrode LGE.

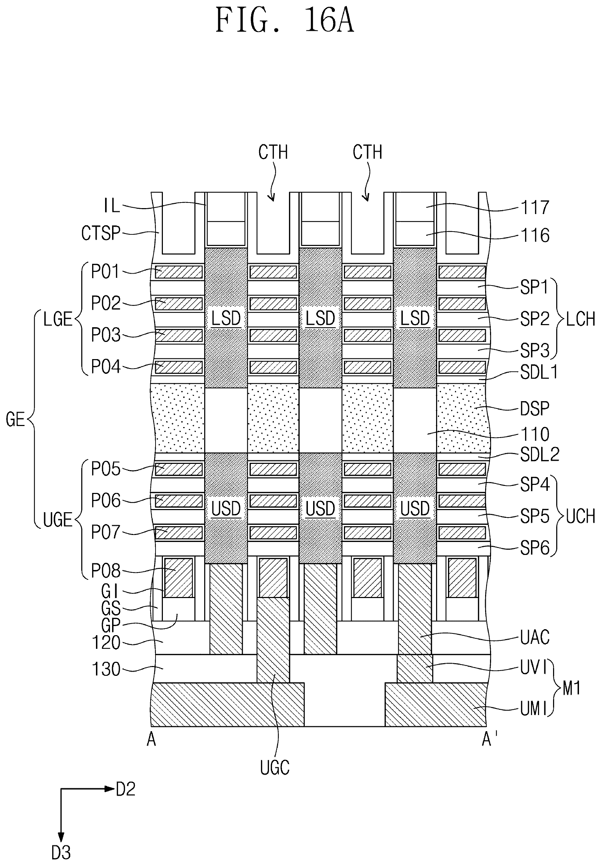

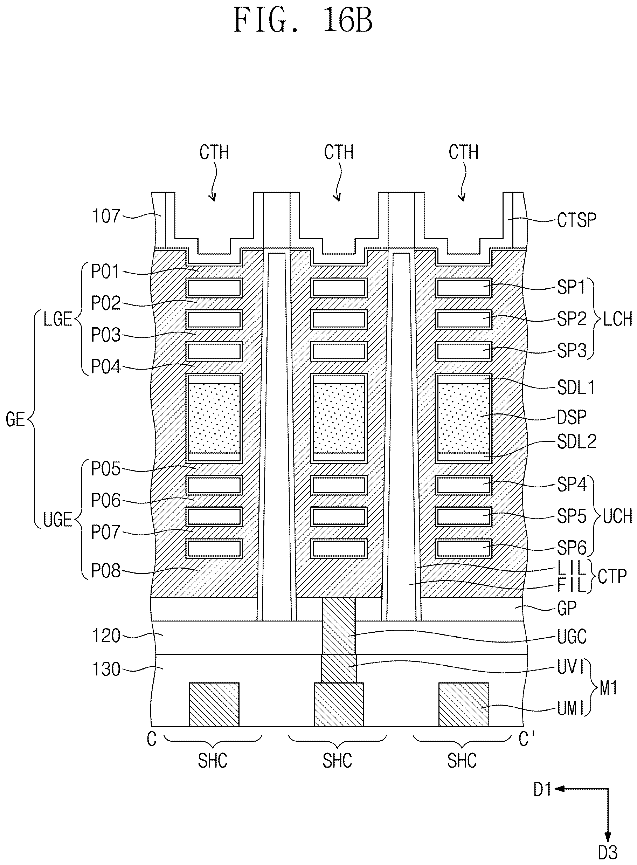

Referring to FIGS. 16A and 16B, a contact spacer CTSP may be conformally formed in the contact holes CTH. The contact spacer CTSP may cover the bottom surface of the exposed lower gate electrode LGE, the sidewall of the element isolation layer 107 and the sidewall of the second insulating layer IL. The contact spacer CTSP may include an insulating material. For example, the contact spacer CTSP may include at least one of SiCN, SiCON, or SiN.

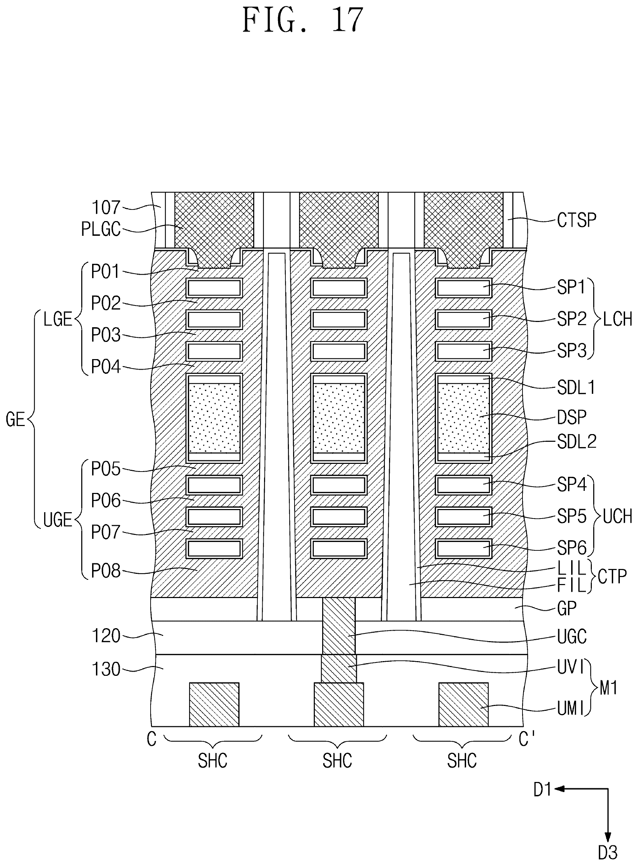

Referring to FIG. 17, an etching process may be performed in the contact holes CTH. Accordingly, the contact spacer CTSP and the gate insulating layer GI may be partially removed. In addition, the first inner electrode PO1 of the lower gate electrode LGE may be partially etched and exposed. The contact spacer CTSP may be etched to be divided into the first and second contact spacers CTSP1 and CTSP2 (see FIG. 5A). In addition, the second contact spacer CTSP2 may have a convex sidewall (see FIG. 5A).

Thereafter, a preliminary lower gate contact PLGC may be formed by filling the contact holes CTH with a conductive material. For example, the preliminary lower gate contact PLGC may include a metal selected from the group consisting of copper (Cu), aluminum (Al), ruthenium (Ru), cobalt (Co), tungsten (W), molybdenum (Mo) and a combination thereof.

Referring back to FIGS. 4A, 4B, 4C, and 5A, the lower gate contact LGC may be formed by performing a planarization process on a rear surface of the preliminary lower gate contact PLGC. A height of the preliminary lower gate contact PLGC may be reduced in the planarization process. Accordingly, a height of each of the element isolation layer 107 and the first contact spacer CTSP1 may be reduced together.

The first lower interlayer insulating layer 200 may be formed on the lower gate contact LGC and the element isolation layer 107. The lower active contact LAC may be formed to penetrate the first lower interlayer insulating layer 200 to be connected to the lower source/drain pattern LSD.

The second lower interlayer insulating layer 210 may be formed on the first lower interlayer insulating layer 200. The backside metal layer BSM may be formed in the first and second lower interlayer insulating layers 200 and 210. The backside metal layer BSM may include the lower lines LMI. The lower vias LVI may be formed to electrically connect the backside metal layer BSM to the lower active contact LAC and the lower gate contact LGC. Additional backside metal layers may be formed on the backside metal layer BSM. According to some implementations of this disclosure, the backside metal layers may include a power transmission network.

A lower gate contact of a three-dimensional semiconductor device according to this disclosure may include a first part, and a second part extending from the first part to be in contact with a lower gate electrode, and the first part may have a greater width than the second part. This is because a buffer layer is formed on a sacrificial contact pattern in a method for manufacturing a three-dimensional semiconductor device according to this disclosure. Accordingly, when a sacrificial layer is removed in order to form an inner electrode, the buffer layer prevents the sacrificial contact pattern from being etched, thereby the sacrificial contact pattern may be prevented from being exposed together and damaged. As a result, reliability and electrical characteristics of the three-dimensional semiconductor device may be improved.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented in combination in a single implementation. Conversely, various features that are described in the context of a single implementation can also be implemented in multiple implementations separately or in any suitable sub-combination. Moreover, although features may be described above as acting in certain combinations, one or more features from a combination can in some cases be excised from the combination, and the combination may be directed to a sub-combination or variation of a sub-combination.

Although implementations of the present invention have been described, it is understood that the present invention should not be limited to these implementations but various changes and modifications can be made by one ordinary skilled in the art within the scope of the present invention as hereinafter claimed.

## Claims

1. A three-dimensional semiconductor device comprising:
a gate electrode (GE) including a lower gate electrode (LGE) and an upper gate electrode (UGE);
a lower active region (LAR) including a lower channel pattern (LCH), a lower source/drain pattern (LSD) connected to the lower channel pattern (LCH), and the lower gate electrode (LGE);
an upper active region (UAR) on the lower active region (LAR) and including an upper channel pattern (UCH), an upper source/drain pattern (USD) connected to the upper channel pattern (UCH), and the upper gate electrode (UGE); and
a lower gate contact (LGC) connected to the lower gate electrode (LGE),
wherein the lower gate contact (LGC) includes:
a first part (PT1); and
a second part (PT2) extending from the first part (PT1) and in contact with the lower gate electrode (LGE),
wherein the first part (PT1) has a greater width than the second part (PT2), and
wherein a sidewall (SW2) of the second part (PT2) has a concave profile.

2. The three-dimensional semiconductor device of claim 1, wherein the lower gate electrode (LGE) extends in a first direction (D1),
wherein the first part (PT1) comprises an upper surface (UW1) extending in the first direction (D1), and
wherein the upper surface (UW1) of the first part (PT1) faces the lower gate electrode (LGE).

3. The three-dimensional semiconductor device of claim 1 or 2, wherein a width (WD2) of the second part (PT2) is smallest on an upper surface (UW2) of the second part (PT2) and increases from the upper surface (UW2) of the second part (PT2) toward a bottom surface of the second part (PT2).

4. The three-dimensional semiconductor device of any preceding claim, wherein the lower channel pattern (LCH) comprises a plurality of stacked lower semiconductor patterns (SP1, SP2, SP3), and
a maximum width (WD2) of the second part (PT2) is the same as, or smaller than, a width (SPWD) of the plurality of stacked lower semiconductor patterns (SP1, SP2, SP3).

5. The three-dimensional semiconductor device of any preceding claim, wherein a ratio of a width (WD1) of the first part (PT1) to a width (WD2) of the second part (PT2) is from 1.5 to 5.

6. The three-dimensional semiconductor device of any preceding claim, wherein the second part (PT2) has a height of from 7 nm to 15 nm.

7. The three-dimensional semiconductor device of any preceding claim, comprising:
a first contact spacer (CTSP1) on a sidewall (SW1) of the first part (PT1); and
a second contact spacer (CTSP2) between the lower gate electrode (LGE) and a sidewall (SW2) of the second part (PT2).

8. The three-dimensional semiconductor device of claim 7, wherein an upper surface of the second contact spacer (CTSP2) is higher than a bottom surface of the lower gate electrode (LGE) and is lower than an upper surface (UW2) of the second part (PT2).

9. The three-dimensional semiconductor device of claim 7 or 8, wherein a width of the second contact spacer (CTSP2) is largest on an upper surface of the second contact spacer (CTSP2) and decreases with increasing distance from the upper surface of the second contact spacer (CTSP2).

10. The three-dimensional semiconductor device of any one of claims 7 to 9, wherein a sidewall of the second contact spacer (CTSP2) has a convex profile corresponding to the sidewall (SW2) of the second part (PT2).

11. The three-dimensional semiconductor device of any one of claims 7 to 10, wherein the lower gate electrode (LGE) extends in a first direction (D1),
wherein the second contact spacer (CTSP2) comprises a first sidewall contact spacer (CTSP2a) on a first sidewall of the second part (PT2), and a second sidewall contact spacer (CTSP2b) on a second sidewall of the second part (PT2),
wherein the first sidewall contact spacer (CTSP2a) comprises a first outer wall adjacent to the lower gate electrode (LGE),
wherein the second sidewall contact spacer (CTSP2b) comprises a second outer wall adjacent to the lower gate electrode (LGE), and
wherein a distance (INT1) in the first direction (D1) between the first outer wall and the second outer wall is the same as a width (SPWD) of the lower channel pattern (LCH).

12. A three-dimensional semiconductor device comprising:
a gate electrode (GE) including a lower gate electrode (LGE) and an upper gate electrode (UGE);
a lower channel pattern (LCH) and a lower active region (LAR) including the lower gate electrode (LGE);
an upper active region (UAR) on the lower active region (LAR) and including an upper channel pattern (UCH) and the upper gate electrode (UGE); and
a lower gate contact (LGC) connected to the lower gate electrode (LGE),
wherein the lower gate electrode (LGE) includes
a first inner electrode (PO1) under the lower channel pattern (LCH), and
an edge electrode (EGP) extending down along a sidewall of the lower channel pattern (LCH),
wherein a bottom surface of the edge electrode (EGP) is lower than a bottom surface of the first inner electrode (PO1),
wherein the lower gate contact (LGC) includes a first part (PT1) and a second part (PT2) on the first part (PT1),
wherein the second part (PT2) protrudes from the first part (PT1) and is in contact with the lower gate electrode (LGE), and
wherein the first part (PT1) includes an upper surface (UW1) facing the lower gate electrode (LGE).

13. The three-dimensional semiconductor device of claim 12, wherein a width (WD2) of the second part (PT2) is smallest on an upper surface (UW2) of the second part (PT2) and increases from the upper surface (UW2) of the second part (PT2) toward a bottom surface of the second part (PT2).

14. The three-dimensional semiconductor device of claim 12 or 13, comprising a contact spacer (CTSP2) between the second part (PT2) and the edge electrode (EGP),
wherein an upper surface of the contact spacer (CTSP2) is higher than a bottom surface of the edge electrode (EGP) and is lower than an upper surface (UW2) of the lower gate contact (LGC).

15. The three-dimensional semiconductor device of claim 14, wherein a sidewall (SW2) of the second part (PT2) has a concave profile, and
wherein a sidewall of the contact spacer (CTSP2) has a convex profile corresponding to the sidewall (SW2) of the second part (PT2).
